Europäisches Patentamt

European Patent Office

Office européen des brevets

(19)

(11) **EP 0 774 840 B1**

(12) **FASCICULE DE BREVET EUROPEEN**

(45) Date de publication et mention
de la délivrance du brevet:
**08.05.2002 Bulletin 2002/19**

(51) Int Cl.⁷: **H03M 13/00**

(21) Numéro de dépôt: **96402403.8**

(22) Date de dépôt: **12.11.1996**

(54) **Procédé de transmission d'une séquence de bits d'information avec protection sélective contre les erreurs de transmission, procédés de codage et de correction pouvant être mis en oeuvre dans un tel procédé de transmission**

Informationsbitfolgeübertragungsverfahren mit selektivem Schutz gegen Übertragungsfehler sowie Übertragungsverfahren damit

Information bit sequence transmission method with selective protection against transmission errors, transmission method using such a coding and correction method

(84) Etats contractants désignés:
**AT BE CH DE DK ES FI GB GR IE IT LI LU MC NL PT SE**

(30) Priorité: **14.11.1995 FR 9513471**

(43) Date de publication de la demande:
**21.05.1997 Bulletin 1997/21**

(73) Titulaire: **MATRA NORTEL COMMUNICATIONS**
**29000 Quimper (FR)**

(72) Inventeur: **Lasne, Xavier**
**78650 Beynes (FR)**

(74) Mandataire: **Loisel, Bertrand et al**
**Cabinet Plasseraud,**
**84, rue d'Amsterdam**
**75440 Paris Cédex 09 (FR)**

(56) Documents cités:
**EP-A- 0 205 667      EP-A- 0 490 552**
**EP-A- 0 634 840      WO-A-89/09965**

• **IEE PROCEEDINGS I. SOLID- STATE & ELECTRON DEVICES, vol. 140, no. 2 PART I, 1 Avril 1993, pages 97-103, XP000362967 ATUNGSIRI S A ET AL: "ERROR CONTROL FOR LOW-BIT-RATE SPEECH COMMUNICATION SYSTEMS"**

## Description

La présente invention concerne le domaine de la transmission d'informations binaires, et plus particulièrement des procédés permettant de protéger certains au moins des bits à transmettre vis-à-vis d'erreurs susceptibles d'être introduites par un canal de transmission.

Par "canal de transmission", on entend ici tout trajet suivi par un signal porteur des bits d'information entre un dispositif émetteur et un dispositif récepteur. Les canaux de transmission incluent ainsi les liaisons radio, filaires ou autres établies entre le dispositif émetteur et le dispositif récepteur, mais également, dans des applications de stockage, des canaux comportant une mémoire dans laquelle les informations délivrées par le dispositif émetteur sont stockées en attendant d'être lues par un dispositif récepteur.

Les techniques de codage canal ont été développées pour procurer une certaine immunité vis-à-vis des erreurs résultant du canal de transmission. En particulier, les techniques de codage correcteur à redondance sont largement utilisées pour détecter et/ou corriger des erreurs. Ces techniques comprennent les codages convolutionnels et les codages en blocs. Le principe d'un codeur redondant est de délivrer n bits caractérisant k bits d'information à transmettre, avec n>k. Le rapport k/n définit le rendement du code, qui ne doit pas être trop bas pour ne pas être pénalisant en termes de bande passante requise. Pour accroître les capacités de correction d'un code de rendement donné, on a habituellement recours à des codeurs et surtout à des décodeurs sensiblement plus complexes (longueur de contrainte augmentée dans le cas d'un code convolutionnel, ou longueur des blocs augmentée dans le cas d'un code en blocs).

Certains codeurs canal procurent plusieurs classes de protection pour les bits d'une trame. Chaque classe de protection correspond à l'application d'un code correcteur de rendement inférieur à 1, avec des capacités de correction différentes d'un code à l'autre. Ceci permet de répartir les bits de la trame entre les classes en fonction de leur importance et d'avoir une protection dépendant de l'importance des bits.

Les codes correcteurs d'erreurs à redondance fournissent les meilleurs résultats lorsque les probabilités d'erreurs sont décorrélées d'un symbole au suivant. Cette condition de décorrélation est satisfaite dans le cas d'un canal à bruit blanc additif gaussien, qui, en pratique, est souvent rencontré avec une bonne approximation. Mais il y a des cas où la condition de décorrélation n'est pas satisfaite, notamment dans le cas de liaisons radio sur un canal de Rayleigh. Un terminal radio mobile, lorsqu'il se déplace, peut traverser des "trous de fading" dans lesquels il reçoit plusieurs versions déphasées du même signal reçu selon des trajets de propagation différents et qui interfèrent de manière destructive. Ces trous de fading peuvent s'étendre sur plusieurs symboles et donc affecter les performances du code correcteur. Pour combattre ce phénomène, la plupart des systèmes radio mobiles utilisent un entrelacement consistant à permuter les symboles d'une ou plusieurs trames successives de manière à mieux satisfaire la condition de décorrélation des probabilités d'erreur sur les symboles des mots de code.

Pour certains systèmes de transmission radio, les bits obtenus après le codage à redondance et le cas échéant l'entrelacement, sont codés différentiellement avant l'émission. Ce codage différentiel consiste à transmettre non pas les bits eux-mêmes, mais la différence entre deux bits successifs. Si $B_0$, $B_1$,..., $B_{N-1}$ désignent la trame de N bits à transmettre, le codage différentiel consiste à réaliser : $B'_n = B'_{n-1} \oplus B_n$ pour $0 \leq n < N$, où $\oplus$ désigne l'opération OU exclusif et $B'_{-1}$ désigne un bit d'initialisation devant lui aussi être transmis ($B'_{-1}$ peut être le dernier bit codé différentiellement de la trame précédente). Le décodage associé est alors simplement : $B_n = B'_{n-1} \oplus B'_n$ pour $0 \leq n < N$. Le codage différentiel n'introduit pas de redondance. La raison pour laquelle on l'utilise tient au problème de l'inversion du vecteur d'onde que posent certains modes de modulation, notamment les modulations GMSK. La poursuite du vecteur d'onde par le démodulateur est difficile, particulièrement quant à la détection de son signe. Lorsque l'amplitude du vecteur d'onde chute en raison d'une perturbation du canal telle qu'un trou de fading, on se retrouve souvent, après la perturbation, avec une ambiguïté sur le signe du vecteur d'onde. Le codage différentiel empêche que les erreurs pouvant résulter de ces inversions de signe se répercutent dans la suite de la trame.

Si ce codage différentiel permet de s'affranchir du problème du signe des bits décodés, il présente l'inconvénient de doubler les erreurs affectant les bits transmis. Si le canal de propagation induit une erreur ponctuelle sur un bit $B'_n$, il en résultera après décodage une erreur sur le bit $B_n$ et une autre sur le bit $B_{n+1}$. Le recours à un codage différentiel augmente donc la probabilité d'erreur de transmission sur les bits de la trame.

Un but de la présente invention est de proposer un procédé de transmission tirant parti des avantages du codage différentiel tout en obtenant une diminution du taux moyen d'erreur au lieu d'une augmentation. Un autre but est de pouvoir protéger plusieurs classes de bit de la séquence à transmettre en conservant un rendement relativement élevé pour le processus global de codage canal.

L'invention propose ainsi un procédé pour transmettre une première séquence de bits d'information, comprenant les étapes suivantes exécutées par un dispositif émetteur :

- formation d'une seconde séquence de bits présentant de la redondance à partir de la première séquence, de façon que la seconde séquence inclue au moins un sous-ensemble redondant constitué de L bits qui représentent M bits de la première séquence avec $0 \leq M < L$ ;

- formation d'une troisième séquence de bits en appliquant à la seconde séquence un codage différentiel de la forme $d_n = c_n \oplus d_{f(n)}$, où $c_n$ et $d_n$ désignent respectivement les bits de rang n de la seconde et de la troisième séquence, $f(n)$ désigne un entier au plus égal à n-1, et $\oplus$ désigne l'opération OU exclusif ; et
- émission d'un signal représentant les bits de la troisième séquence dans un ordre déterminé,

et les étapes suivantes exécutées par un dispositif récepteur :

- obtention de données de vraisemblance $r_n$ à partir du signal reçu du dispositif émetteur par l'intermédiaire d'un canal de transmission, le signe de chaque donnée de vraisemblance $r_n$ représentant une estimation, de fiabilité croissante avec la valeur absolue de $r_n$, de la valeur d'un bit respectif $d_n$ de la troisième séquence ;
- calcul de premières estimations respectives des bits du sous-ensemble redondant, chaque première estimation d'un bit $c_n$ du sous-ensemble redondant dépendant du signe de $r_n.r_{f(n)}$ ;
- détection des bits du sous-ensemble redondant ayant des premières estimations erronées en raison d'erreurs résultant du canal de transmission, en exploitant la redondance présente dans le sous-ensemble redondant ;
- pour chaque bit $c_n$ du sous-ensemble redondant dont la première estimation a été détectée comme erronée, modification du signe de celle des deux données de vraisemblance $r_n$ et $r_{f(n)}$ qui a la plus petite valeur absolue ;
- obtention de secondes estimations respectives des bits de la seconde séquence, la seconde estimation d'un bit $c_n$ de la seconde séquence dépendant du signe de $r_n.r_{f(n)}$ ; et
- obtention d'estimations des bits de la première séquence sur la base des secondes estimations des bits de la seconde séquence.

Une donnée de vraisemblance $r_n$ reçue avec un signe erroné aura en général une valeur absolue faible. Lorsqu'on dispose d'un moyen de savoir si une estimation d'un bit $c_n$ après décodage différentiel est fausse, on peut estimer avec une assez bonne fiabilité quelle est celle des deux données de vraisemblance $r_n$ et $r_{f(n)}$ qui avait un signe faux. C'est dans la plupart des cas la donnée de vraisemblance dont la valeur absolue est la plus faible. La redondance présente dans le sous-ensemble redondant permet justement d'identifier des bits faux, de sorte qu'on peut rectifier les données de vraisemblance associées et faire bénéficier de la rectification d'autres bits n'appartenant pas au sous-ensemble redondant.

Les bits bénéficiant ainsi d'une protection supplémentaire sont ceux de la forme $c_{n'}$ qui n'appartiennent pas au sous-ensemble redondant, et pour lesquels il y a au moins un bit $c_n$ appartenant au sous-ensemble redondant tel que n'=f(n) ou f(n')=n ou f(n).

Cette protection supplémentaire fournie par le codage différentiel ne s'accompagne pas d'une augmentation du débit binaire requis pour la transmission.

Lorsque $M \geq 1$, le sous-ensemble redondant se compose de L bits produits par un codage correcteur d'erreurs à partir de M bits de la première séquence lors de la formation de la seconde séquence.

Lorsque M=0, le sous-ensemble redondant se compose de L bits connus du dispositif récepteur. Ces bits connus peuvent notamment être des bits de synchronisation.

Pour optimiser les capacités de correction d'erreurs, on choisit avantageusement la structure de la seconde séquence et la fonction $f$ de façon à maximiser le nombre L', au plus égal à L, de bits $c_{n'}$ de la seconde séquence n'appartenant pas au sous-ensemble redondant tels qu'il y ait deux bits $c_{n1}$ et $c_{n2}$ du sous-ensemble redondant avec n'=f(n1) et f(n')=n2 ou f(n2). En effet, ces bits $c_{n'}$ bénéficient d'une protection importante étant donné qu'ils sont estimés en fonction de deux données de vraisemblance corrigibles grâce au sous-ensemble redondant.

Un autre aspect de l'invention concerne un procédé de codage d'une première séquence de bits d'information, dans lequel on prévoit au moins une première classe de protection pour M bits de la première séquence et une seconde classe de protection pour M' bits de la première séquence, M et M' désignant deux entiers au moins égaux à 1. Ce procédé de codage comprend les étapes suivantes :

- on forme une seconde séquence de bits présentant de la redondance à partir de la première séquence, de façon que la seconde séquence inclue au moins un premier sous-ensemble redondant constitué de L bits qui représentent les M bits de la première classe de la première séquence avec M<L, et un second sous-ensemble constitué de L' bits qui dépendent des M' bits de la seconde classe de la première séquence ;
- on forme une troisième séquence de bits en appliquant à la seconde séquence un codage différentiel de la forme $d_n = c_n \oplus d_{f(n)}$, où $c_n$ et $d_n$ désignent respectivement les bits de rang n de la seconde et de la troisième séquence, $f(n)$ désigne un entier au plus égal à n-1, et $\oplus$ désigne l'opération OU exclusif ; et
- on délivre un signal représentant les bits de la troisième séquence dans un ordre déterminé,

la structure de la seconde séquence et la fonction $f$ étant choisies de façon que pour chaque bit $c_{n'}$ appartenant au second sous-ensemble de la seconde séquence, il y ait au moins un bit $c_n$ appartenant au premier sous-ensemble de la seconde séquence tel que n'=f(n) ou f(n')=n ou f(n).

Un troisième aspect de la présente invention se rapporte à un procédé de correction d'une séquence de données de vraisemblance $r_n$ obtenues à partir d'un signal reçu d'un dispositif émetteur par l'intermédiaire d'un canal de transmission, le signe de chaque donnée de vraisemblance $r_n$ représentant une estimation, de fiabilité croissante avec la valeur absolue de $r_n$, de la valeur d'un bit respectif $d_n$ d'une séquence codée de bits résultant d'un codage différentiel d'une seconde séquence de bits par le dispositif émetteur, la seconde séquence de bits incluant au moins un sous-ensemble redondant constitué de L bits qui représentent M bits d'information à communiquer avec $0{\leq}M{<}L$. Ledit codage différentiel étant de la forme $d_n=c_n{\oplus}d_{f(n)}$, $c_n$ et $d_n$ désignant respectivement les bits de rang n de la seconde séquence et de la séquence codée, f(n) désignant un entier au plus égal à n-1, et $\oplus$ désignant l'opération OU exclusif, le procédé de correction comporte les étapes suivantes :

- calcul de premières estimations respectives des bits du sous-ensemble redondant, chaque première estimation d'un bit $c_n$ dudit sous-ensemble dépendant du signe de $r_n{\cdot}r_{f(n)}$ ;
- détection des bits du sous-ensemble redondant ayant des premières estimations erronées en raison d'erreurs résultant du canal de transmission, en exploitant la redondance présente dans le sous-ensemble redondant ; et
- pour chaque bit $c_n$ du sous-ensemble redondant dont la première estimation a été détectée comme erronée, modification du signe de celle des deux données de vraisemblance $r_n$ et $r_{f(n)}$ qui a la plus petite valeur absolue.

D'autres particularités et avantages de la présente invention apparaîtront dans la description ci-après d'exemples de réalisation non limitatifs, en référence aux dessins annexés, dans lesquels :

- les figures 1 à 6 sont des diagrammes illustrant différents modes de codage différentiel utilisables dans un procédé selon l'invention ;
- la figure 7 est un schéma illustrant différentes étapes d'un exemple de procédé de codage selon l'invention ; et
- la figure 8 est un schéma montrant différentes étapes d'un procédé de décodage correspondant au procédé de codage de la figure 7.

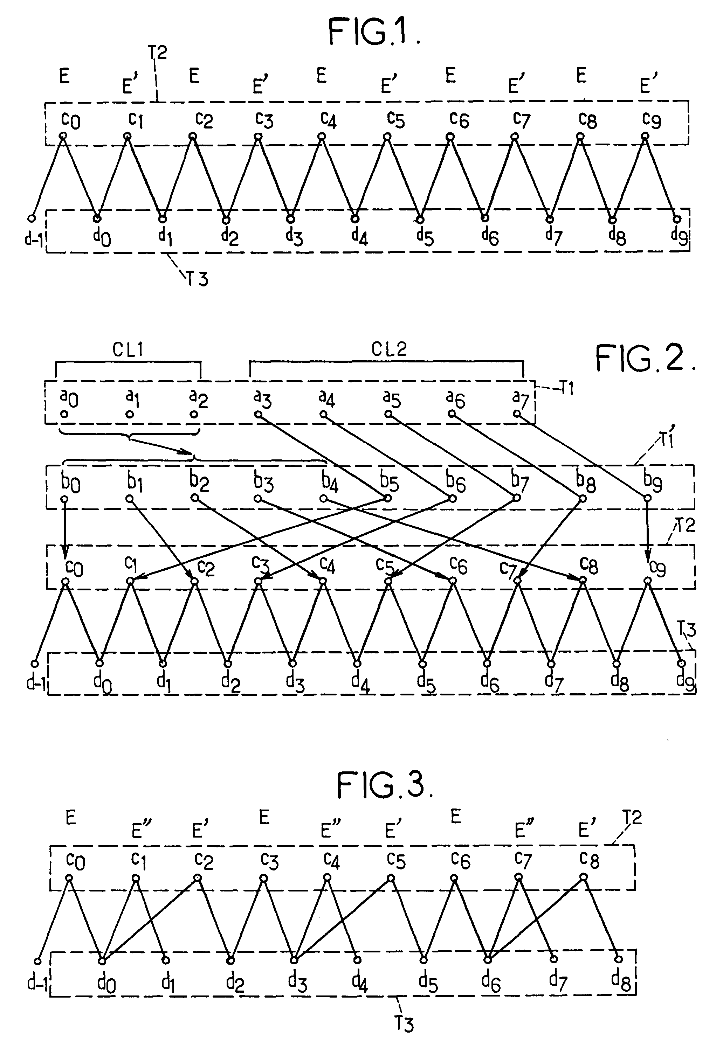

La figure 1 montre une séquence T2 de bits $c_0$, $c_1$,... formée à partir d'une séquence T1 (non représentée sur la figure 1) de bits d'information à transmettre $a_0$, $a_1$,... On considère ici que chaque séquence T1, T2 se compose d'un nombre donné de bits, la séquence, ou trame, T2 présentant de la redondance par rapport à la séquence, ou trame, T1 et ayant donc un nombre de bits N plus grand que celui K de la trame T1. Dans l'exemple simplifié considéré ici, la longueur N de la trame T2 est de 10, la trame T1 ayant par exemple une longueur K=8. On suppose que la trame T2 inclut un sous-ensemble redondant E constitué de L=5 bits $c_0$, $c_2$, $c_4$, $c_6$ et $c_8$, les L'=5 autres bits de la trame constituant un sous-ensemble E'.

Le codage différentiel transforme la trame T2 en une séquence ou trame T3 ayant le même nombre de bits N. Le codage différentiel illustré par les lignes obliques sur la figure 1 est simplement $d_n=c_n{\oplus}d_{n-1}$, c'est-à-dire qu'avec les notations utilisées précédemment, $f$ est la fonction f(n)=n-1. Les trames T3 étant émises en succession, le bit d'initialisation $d_{-1}$ est par exemple le dernier bit de la précédente trame T3.

Etant donné que les bits des sous-ensembles E et E' apparaissent en alternance dans la trame T2, chaque bit $d_n$ de la trame T3 intervient dans le codage d'un bit du sous-ensemble redondant E, à savoir le bit $c_{n+(n\ modulo\ 2)}$. Au niveau du dispositif récepteur, la première estimation de ce bit $c_{n+(n\ modulo\ 2)}$ sera corrigible en exploitant la redondance présente dans le sous-ensemble E, ce qui permettra éventuellement en cas de correction d'inverser l'estimation du bit $d_n$ de la troisième trame, cette inversion permettant ensuite de corriger également l'estimation du bit $c_{n+1-(n\ modulo\ 2)}$ appartenant au sous-ensemble E'.

Pour chaque trame T3, le dispositif récepteur obtient un signal constitué de N valeurs réelles ou softbits $r_0$, $r_1$,..., $r_{N-1}$ de la forme $r_n=A_n(1-2d_n)+B_n$ où $A_n$ est le niveau d'énergie relatif du signal reçu (dans certains cas, le signe de $A_n$ n'est pas connu a priori) et $B_n$ est un échantillon de bruit. Les valeurs $r_n$ peuvent être vues comme des données de vraisemblance associées aux bits $d_n$, étant donné qu'on montre aisément, pour un canal à bruit blanc additif gaussien, que $r_n$ est proportionnelle à $\ln[Pr\{d_n=0|r_n\}/Pr\{d_n=1|r_n\}]$ où $Pr\{d_n=i|r_n\}$ désigne la probabilité pour de $d_n=i$ sachant que la valeur $r_n$ a été reçue. En d'autres termes, le signe de $r_n$ constitue une estimation de la valeur du bit $d_n$ tandis que la valeur absolue de $r_n$ est une mesure de la fiabilité de cette estimation.

Compte tenu du codage différentiel utilisé, le dispositif récepteur peut calculer des premières estimations $\hat{c}_n$ des bits $c_n=d_n{\oplus}d_{f(n)}$ de la trame T2 en fonction du signe $\mathrm{sgn}(r_n{\cdot}r_{f(n)})={\pm}1$ de $r_n{\cdot}r_{f(n)}$ et éventuellement des valeurs absolues de $r_n$ et $r_{f(n)}$. Ces premières estimations peuvent être des décisions dures, par exemple $\hat{c}_n=\mathrm{sgn}(r_n{\cdot}r_{f(n)})$ (soit $\hat{c}_n=1-2c_n$ en l'absence d'erreurs de transmission) ou des décisions douces de la forme $\hat{c}_n=\mathrm{sgn}(r_n{\cdot}r_{f(n)}){\cdot}g(|r_n|,|r_{f(n)}|)$ où g est une fonction mesurant la fiabilité de l'estimation, par exemple g(x,y)=xy. On note que, grâce au codage différentiel, une éventuelle ambiguïté sur le signe des niveaux d'énergie $A_n$ n'affecte pas les estimations $\hat{c}_n$. Si l'exploitation de la redondance prévue dans le sous-ensemble E montre que la première estimation $\hat{c}_n$ d'un bit $c_n$ du sous-ensemble E est erronée, c'est parce que le signe de $r_n$ ou celui de $r_{f(n)}$ est faux. On inverse alors le signe de celle des deux données $r_n$, $r_{f(n)}$ qui est considérée comme la moins fiable, c'est-à-dire qui a la plus faible valeur absolue. Dans la mesure où cette donnée dont le signe a été inversé intervient dans le décodage différentiel d'un autre bit de la trame T2 (ou plusieurs), celui-ci pourra également bénéficier de la correction apportée lors d'un second décodage différentiel des données de vraisemblance.

Si on suppose que la correction des premières estimations des bits du sous-ensemble E fournit des résultats certains, on peut évaluer la probabilité d'erreur sur le signe d'une donnée de vraisemblance $r_n$ intervenant dans le décodage différentiel d'un bit du sous-ensemble E :

$$Pr_{err}(r_n) = \frac{1}{2} \, Erfc\left(\sqrt{\frac{2Eb}{N_0}}\right) \tag{1}$$

où *Erfc* désigne la fonction erreur et $Eb/N_0$ désigne le rapport signal-à-bruit.

On désigne par E' le sous-ensemble de cardinal $L' \leq \min(L, N-L)$ de la trame T2, composé des bits $c_{n'}$ n'appartenant pas au sous-ensemble E et tels que deux bits $c_{n1}$ et $c_{n2}$ du sous-ensemble redondant E vérifient $n'=f(n1)$ et $f(n')=n2$ ou $f(n2)$. Ces bits $c_{n'}$ bénéficient d'une protection double étant donné que les deux données de vraisemblance associées $r_{n'}$, et $r_{f(n')}$ sont corrigibles. Il découle de la relation (1) que la probabilité d'erreur sur un bit du sous-ensemble E' est :

$$Pr_{err}(c_{n'}) \approx Erfc\left(\sqrt{\frac{2Eb}{N_0}}\right) \tag{2}$$

Cette probabilité $P_{err}(c_{n'})$ est sensiblement inférieure à celle qu'on obtient en n'utilisant pas de codage différentiel avant l'émission.

On désigne par E" le sous-ensemble de cardinal $L'' \leq N-L-L'$ de la trame T2, composé des bits $c_{n''}$ tels qu'il existe un et un seul bit $c_n$ du sous-ensemble redondant E vérifiant $n''=f(n)$ ou $f(n'')=n$ ou $f(n)$. Ces bits $c_{n''}$ bénéficient d'une protection simple. Il découle de la relation (1) que la probabilité d'erreur sur un bit du sous-ensemble E" est :

$$Pr_{err}(c_{n''}) \approx \frac{1}{2} \left(Erfc\left(\sqrt{\frac{Eb}{N_0}}\right) + Erfc\left(\sqrt{\frac{2Eb}{N_0}}\right)\right) \tag{3}$$

Cette probabilité $P_{err}(c_{n''})$ est du même ordre que celle qu'on obtient en n'utilisant pas de codage différentiel avant l'émission.

On désigne par E'" le sous-ensemble de cardinal L'" de la trame T2, composé des bits $c_{perm(n'')}$ n'appartenant ni à E, ni à E', ni à E". Ces bits ne bénéficient pas d'une protection par l'intermédiaire du codage différentiel. La probabilité d'erreur associée

$$Pr_{err}(c_{n'''}) \approx Erfc\left(\sqrt{\frac{Eb}{N_0}}\right) \tag{4}$$

montre une dégradation de 3dB du taux d'erreur binaire par rapport au cas où on n'utilise pas de codage différentiel. En général, on pourra choisir une structure de la trame T2, et une fonction *f* pour lesquelles le sous-ensemble E'" est vide (L'"=0).

La structure de la trame T2 et la fonction *f* sont de préférence choisies de façon à maximiser le cardinal L' du sous-ensemble E'. Idéalement, le sous-ensemble E' comprend tous les bits de la trame T2 n'appartenant pas au sous-ensemble redondant E, comme dans le cas de la figure 1. Cette condition peut être satisfaite lorsque $L \geq N/2$.

On voit que, dans l'exemple considéré sur la figure 1, tous les bits de la trame T2 bénéficient d'une protection contre les erreurs de transmission, bien que la redondance ne soit appliquée qu'au sous-ensemble E. Le codage différentiel a donc pu introduire une protection spécifique pour certains bits de la trame, sans diminuer le rendement global du codage canal.

La correction du signe des données de vraisemblance $r_n$, $r_{f(n)}$ associées aux bits $c_n$ du sous-ensemble redondant E peut être accompagnée par une modification des fiabilités de ces données. Par exemple, si les $\hat{c}_n$ désignent les premières estimations respectives des bits $c_n$ du sous-ensemble redondant et, si les $\hat{c}'_n$ désignent ces mêmes estimations après la correction effectuée sur la base de la redondance présente dans le sous-ensemble E (avec $\hat{c}'_n = c_n = 0$ ou 1 en l'absence d'erreurs), il est possible de transformer les données de vraisemblance $r_n$ selon les relations :

$$r'_n = [r_n + r_{f(n)} \cdot (1 - 2\hat{c}'_n)] / \sqrt{2} \qquad (5)$$

et

$$r'_{f(n)} = r'_n \cdot (1 - 2\hat{c}'_n) \qquad (6)$$

Ces relations (5) et (6) opèrent la modification de signe nécessaire lorsque $\mathrm{sgn}(\hat{c}_n) \neq 1 - 2\hat{c}'_n$. Elles ajustent en outre les fiabilités $|r'_n|$ et $|r'_{f(n)}|$, avec $|r'_n| = |r'_{f(n)}|$, ce qui présente un intérêt lorsque les traitements appliqués aux données de vraisemblance impliquent des processus de décision douce. Ainsi, si une donnée de vraisemblance (par exemple $r_n$) dont le signe a été modifié était initialement relativement fiable ($|r_n|$ relativement importante), la valeur absolue de l'autre donnée de vraisemblance est généralement assez proche ($|r_{f(n)}| \gtrsim |r_n|$), et les relations (5) et (6) produisent des fiabilités $|r'_n|$ et $|r'_{f(n)}|$ relativement faibles, ce qui rend compte du fait que la probabilité pour que la modification du signe soit a priori justifiée n'est que peu supérieure à 50%. Si en revanche le signe de $r_n$ est à modifier alors que $|r_n| \ll |r_{f(n)}|$, la modification du signe est très vraisemblablement justifiée, et les relations (5) et (6) affectent des fiabilités relativement élevées aux données modifiées $r'_n$ et $r'_{f(n)}$. Cet ajustement des fiabilités $|r'_n|$ et $|r'_{f(n)}|$ intervient également à l'égard des bits $c_n$ du sous-ensemble redondant E pour lesquels le processus de correction ne révèle pas d'erreur.

Comme indiqué précédemment, les bits du sous-ensemble E peuvent être des bits connus du récepteur tels que des bits de synchronisation. Les bits de synchronisation apparaissent dans chacune des trames successives, de sorte qu'une erreur affectant l'un de ces bits de synchronisation connus peut être rectifiée, par exemple grâce au fait que la synchronisation est déjà en partie réalisée par l'analyse des trames précédentes. La formation de la seconde trame T2 par le dispositif émetteur inclut alors l'adjonction à la trame T1 des bits de synchronisation et leur répartition parmi les bits de la trame T1. Si un entrelacement des bits de la trame T1 est nécessaire, il peut être effectué avant l'adjonction des bits de synchronisation.

La redondance présente dans le sous-ensemble E peut également découler d'un codage correcteur d'erreurs mis en oeuvre lors de la formation de la trame T2 à partir de la trame T1. Ainsi, dans l'exemple illustré sur la figure 2, le sous-ensemble E des bits de rang pair de la trame T2 se compose de L=5 bits qui dépendent seulement de M=3 bits de la trame T1 des bits d'information à transmettre. Dans cet exemple, la trame T1 se compose de K=8 bits d'information dont une classe CL1={$a_0$, $a_1$, $a_2$} est codée avec redondance dans le sous-ensemble E. La trame T1 comporte une seconde classe CL2 constituée des M'=5 autres bits $a_3$ à $a_7$ qui sont reproduits sans redondance dans le sous-ensemble E' (L'=M'). On observera toutefois que le sous-ensemble E' pourrait également comporter une certaine redondance (c'est-à-dire L'>M'). Dans l'exemple représenté sur la figure 2, la formation de la trame T2 à partir de la trame T1 s'effectue en deux étapes. La première étape consiste à adjoindre deux bits de redondance aux bits de la classe CL1 (de manière systématique ou non systématique) pour établir le sous-ensemble redondant E au début d'une trame T1' de N=10 bits $b_n$. Les cinq autres bits de la trame T1' sont les bits de classe CL2 décalés de deux positions. Si le codage différentiel illustré sur la figure 1 était simplement appliqué à la trame T1', seul le bit $b_5$ du sous-ensemble E' bénéficierait d'une certaine protection (par le biais du bit $d_4$). Pour optimiser les capacités de correction, on applique aux bits de la trame T1' une permutation appropriée pour établir l'alternance désirée entre les bits des sous-ensembles E et E'. Dans l'exemple représenté sur la figure 2, cette permutation est $c_n = b_{\mathrm{perm}(n)}$ avec perm(n)=n/2 si n est pair et perm (n) = (n+9)/2 si n est impair ($0 \leq n \leq 9$). La trame T2 ainsi obtenue peut alors être codée différentiellement de la même manière que sur la figure 1 pour obtenir la trame T3.

Si un entrelacement des bits est nécessaire, par exemple pour tenir compte d'un canal de Rayleigh, cet entrelacement peut être effectué lors du passage de la trame T1' à la trame T2. En effet, un entrelacement n'est rien d'autre qu'une permutation de bits. L'entrelacement produit un certain mélange entre les bits, mais a priori ce mélange ne suffit pas à assurer l'alternance entre les bits des sous-ensembles E et E' dont on a besoin pour optimiser les capacités de correction. Ainsi, la permutation définie par un entrelacement classique devra être retouchée localement pour bien distribuer les bits des sous-ensembles E et E' sans réintroduire de corrélations entre les probabilités d'erreurs sur des bits voisins.

Dans un cas où l'entrelacement s'étend sur plusieurs trames T1', la trame T2 s'entend comme étant le segment de la séquence binaire entrelacée qui inclut tous les bits d'une trame T1'. Les trames T2 successives peuvent notamment présenter des recouvrements mutuels si un entrelacement diagonal est utilisé.

On observera que la trame T2 pourrait ne pas être produite sous forme explicite au niveau du codeur. Ainsi, le codage différentiel pourrait être réalisé directement à partir de la trame T1' selon $d_n = b_{perm(n)} \oplus d_{f(n)}$ où *perm* est la permutation précitée sur les entiers 0 à N-1 (c'est-à-dire assurant l'alternance entre les bits des sous-ensembles E et E' et le cas échéant un entrelacement).

Dans les cas particuliers des figures 1 et 2, la fonction *f* utilisée dans le codage différentiel est la fonction f(n)=n-1. Cette fonction convient lorsque le nombre L de bits du sous-ensemble redondant E est au moins égal à la moitié de la longueur N des trames T2 et T3, pourvu qu'on adopte une structure appropriée de la trame T2 (ou une permutation *perm* adéquate). Chacun des bits de la trame T2 appartient alors soit au sous-ensemble redondant E, soit au sous-ensemble E'.

Mais si L<N/2, cette condition n'est plus satisfaite puisque le cardinal L' de E' ne peut pas dépasser celui L de E. Il est alors judicieux de modifier la fonction f afin de maximiser le cardinal de E'. La figure 3 illustre ainsi un cas où le sous-ensemble redondant E se compose de L=N/3 bits de rang 3i, pour i=0,1,.... On maximise dans ce cas le cardinal L' avec la fonction f(3i)=3i-1, f(3i+1)=3i, f(3i+2)=3i pour i=0,1,.... Les bits de rang 3i+2 composent le sous-ensemble E' des bits doublement protégés. Les bits de rang 3i+1 constituent le sous-ensemble E" de cardinal L"=L'=L=N/3 : la donnée de vraisemblance $r_{3i}$ pourra être corrigée, mais non la donnée de vraisemblance $r_{3i+1}$. Dans l'exemple de la figure 3, la trame T1 des bits d'information à transmettre peut être décomposée en trois classes CL1, CL2, CL3 ayant respectivement M<L, M'≤L' et M"≤L" bits et qui définissent respectivement les bits des sous-ensembles E, E' et E". Les bits de ces trois classes ont des niveaux de protection différents.

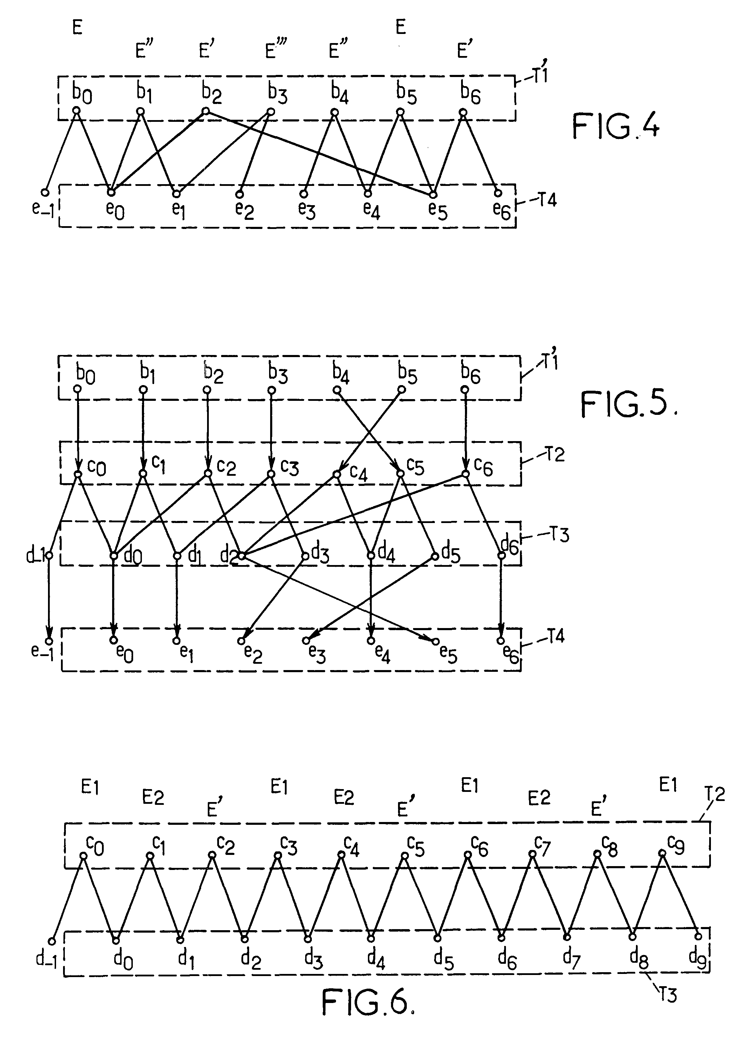

On note que l'ordre dans lequel sont émis les bits $d_n$ de la trame T3 pourrait ne pas être l'ordre présent en sortie du codeur différentiel. La trame T3 pourrait ainsi être réordonnée avant l'émission pour former une trame d'émission T4=$(e_0, e_1, ..., e_{N-1})$ avec $e_{perm'(n)} = d_n$ pour 0≤n<N, perm' désignant une permutation sur les entiers 0 à N-1. En particulier, un entrelacement pourrait être effectué sur la trame codée différentiellement. Dans un tel cas, si $s_0, s_1, ..., s_{N-1}$ désignent les données de vraisemblance obtenues par le dispositif récepteur à l'égard des bits $e_0, e_1, ..., e_{N-1}$, les données de vraisemblance $r_0, r_1, ..., r_{N-1}$ correspondant aux bits $d_0, d_1, ..., d_{N-1}$ de la trame T3, utilisées pour le décodage différentiel, sont données par $r_n = s_{perm'(n)}$. De façon générale, on peut visualiser le processus de codage différentiel comme un graphe faisant correspondre deux bits distincts de la trame émise T4 à chaque bit d'une trame T1' présentant de la redondance, ce graphe ne comportant aucune boucle fermée. Par exemple, la transformation T1'→T4 représentée sur la figure 4 peut se décomposer en $e_{perm'(n)} = d_n$ avec $d_n = b_{perm(n)} \oplus d_{f(n)}$ où *perm*, *perm'* et *f* sont données par le tableau I, comme le montre la figure 5. On note que l'exemple illustratif des figures 4 et 5 n'est pas optimal parce que E'''≠∅. En outre, le bit $b_2$ sera sensible à une inversion (non corrigible) du vecteur d'onde survenant entre les bits $e_0$ et $e_5$. En règle générale, on n'a pas intérêt à ce que deux bits trop éloignés de la trame émise codent un bit de la trame T1' ou T2 lorsque le problème de l'inversion du vecteur d'onde peut se poser.

TABLEAU I

| n | 0 | 1 | 2 | 3 | 4 | 5 | 6 |
|---|---|---|---|---|---|---|---|
| perm (n) | 0 | 1 | 2 | 3 | 5 | 4 | 6 |
| perm '(n) | 0 | 1 | 5 | 2 | 4 | 3 | 6 |
| f(n) | -1 | 0 | 0 | 1 | 2 | 4 | 2 |

On note encore que le procédé selon l'invention est parfaitement compatible avec les procédés d'embrouillage classiquement utilisés dans les communications radio. L'embrouillage consiste à inverser certains des bits afin d'obtenir une répartition quasi-aléatoire des 0 et des 1 à l'émission. Ceci est réalisé en soumettant la séquence des bits à émettre à une opération OU exclusif avec une séquence binaire dans laquelle les bits à 1 indiquant les positions des bits à inverser, la même opération étant réalisée par le récepteur pour désembrouiller. Dans le cadre de l'invention, un embrouillage peut être effectué avant le codage différentiel (lors de la formation de la trame T2) ou après le codage différentiel (lors du passage de la trame T3 à la trame T4). Chaque bit $e_j$ de la trame émise T4 doit être représentatif d'un bit $d_n$ de la trame T3, avec éventuellement j≠n et éventuellement des inversions en des positions connues de l'émetteur et du récepteur.

Dans les exemples décrits en référence aux figures 1 à 5, la trame T2 inclut un seul sous-ensemble redondant E procurant une protection que le codage différentiel permet d'étendre dans une certaine mesure à d'autres bits de la trame T2. L'invention permet néanmoins de prévoir un nombre Q plus grand que 1 de tels sous-ensembles redondants

$E_1$, ..., $E_Q$. Chaque sous-ensemble $E_q$ ($1 \leq q \leq Q$) se compose de $L_q$ bits dépendant de $M_q$ bits de la trame T1, avec $0 \leq M_q < L_q < N$. La figure 6 illustre ainsi un cas où sont prévus $Q=2$ sous-ensembles redondants $E_1 = \{c_0, c_3, c_6, c_9\}$ et $E_2 = \{c_1, c_4, c_7\}$ dans une trame T2 de longueur $N=10$. La correction des données de vraisemblance $r_n$ peut alors être un processus à Q étages (ou moins), chaque étage comportant, pour l'un des ensembles $E_q$ :

- le calcul de premières estimations $\hat{c}_n$ des bits de $E_q$ en fonction du signe de $r_n . r_{f(n)}$ (et éventuellement de $|r_n|$ et $|r_{f(n)}|$) ;
- la détection de celles des premières estimations $\hat{c}_n$ des bits de $E_q$ qui sont erronées, en exploitant la redondance présente dans $E_q$ pour corriger d'éventuelles erreurs dans les premières estimations $c_n$ ; et
- l'inversion du signe de chaque donnée de vraisemblance $r_n$ telle que $\hat{c}_n$ a été détectée comme erronée et $|r_n| < |r_{f(n)}|$ et de chaque donnée de vraisemblance $r_{f(n)}$ telle que $\hat{c}_n$ a été détectée comme erronée et $|r_{f(n)}| < |r_n|$.

Dans l'exemple de la figure 6, le premier étage relatif au sous-ensemble $E_1$ permet de corriger les données $r_0$, $r_2$, $r_3$, $r_5$, $r_6$, $r_8$ et $r_9$. Supposons par exemple que le code redondant utilisé pour obtenir les bits du sous-ensemble $E_2$ permette la correction d'une erreur seulement. Supposons également que les signes des données $r_4$ et $r_6$ soient erronées à la réception. La donnée $r_6$ pourra être corrigée lors du premier étage de correction et la donnée $r_4$ lors du second étage de correction, alors qu'une telle correction double n'aurait pas été possible si on avait cherché à décoder le sous-ensemble $E_2$ dès le premier étage. L'invention permet dans ce cas d'améliorer les capacités de correction attachées au(x) sous-ensemble(s) $E_q$ avec $q>1$. La protection des bits du sous-ensemble $E'=\{c_2, c_5, c_8\}$ s'en trouve également renforcée.

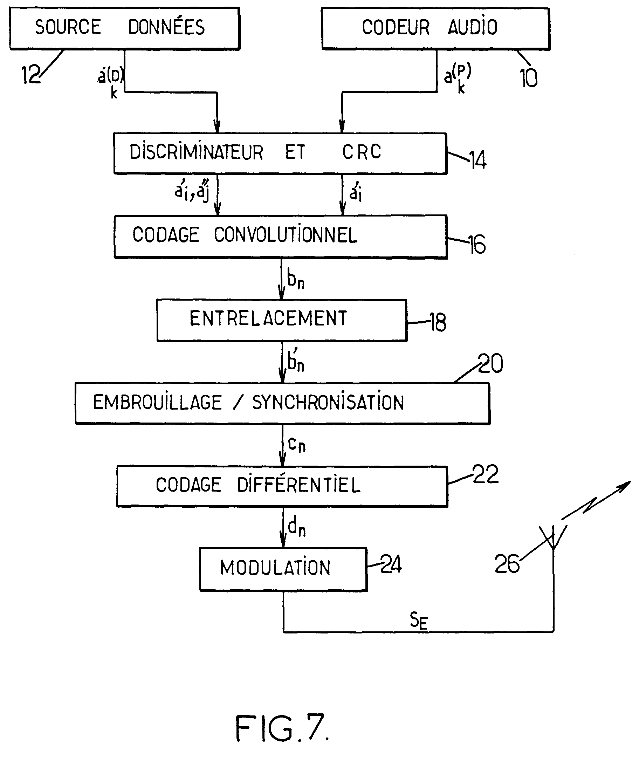

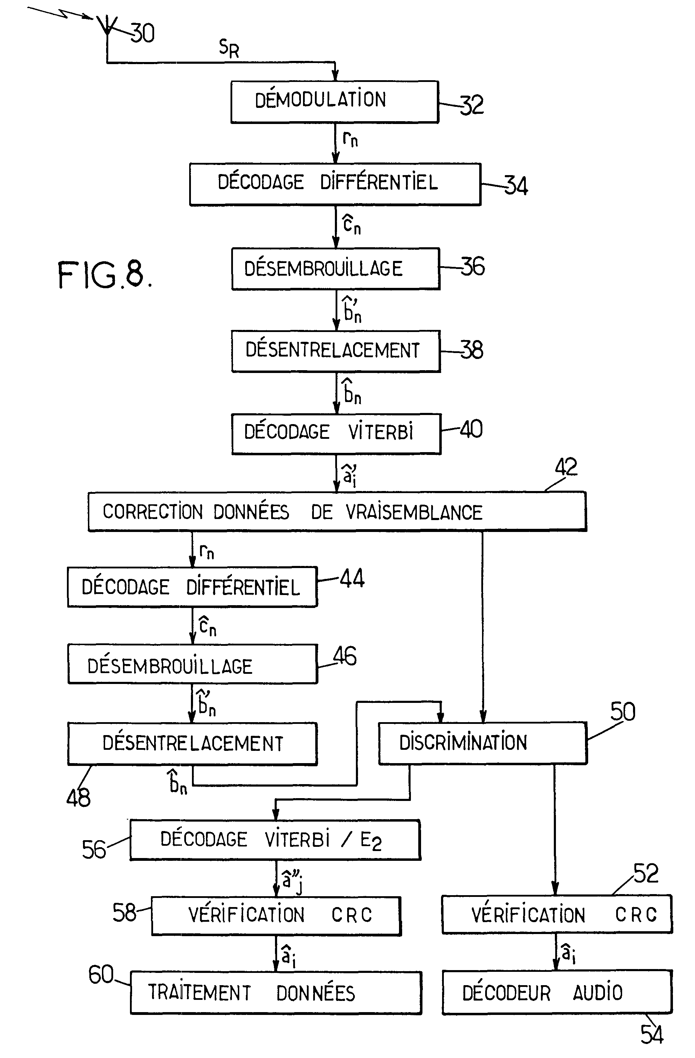

On va maintenant illustrer l'invention par un exemple particulier d'une liaison radio permettant la transmission de données et de phonie entre un émetteur et un récepteur. La longueur des trames transmises est de 160 bits dont 8 bits de synchronisation dans cet exemple. Les figures 7 et 8 sont des schémas synoptiques des dispositifs émetteur et récepteur utilisés.

Le dispositif émetteur comprend un codeur audio 10 délivrant des trames de phonie T1 de $K^{(P)}=120$ bits $a_0^{(P)}$,..., $a_{119}^{(P)}$, parmi lesquels les $M^{(P)}=20$ premiers $a_0^{(P)}$,..., $a_{19}^{(P)}$ sont affectés à une classe de protection $CL1^{(P)}$, les $M'^{(P)}=52$ suivants $a_{20}^{(P)}$,..., $a_{71}^{(P)}$ sont affectés à une classe de protection $CL2^{(P)}$, et les $M''^{(P)}=48$ derniers $a_{72}^{(P)}$,..., $a_{119}^{(P)}$ sont affectés à une classe de protection $CL3^{(P)}$. Les classes $CL1^{(P)}$, $CL2^{(P)}$ et $CL3^{(P)}$ correspondent à des niveaux de protection décroissants. Le dispositif émetteur comprend d'autre part une source de données 12 délivrant des trames de données de $K^{(D)}=66$ bits $a_0^{(D)}$,..., $a_{65}^{(D)}$, parmi lesquels les $M^{(D)}=23$ premiers $a_0^{(D)}$,..., $a_{22}^{(D)}$ sont affectés à une classe de protection $CL1^{(D)}$ et les $M'^{(D)}=23$ suivants $a_{23}^{(D)}$,..., $a_{45}^{(D)}$ sont affectés à une classe de protection $CL2^{(D)}$ et les $M''^{(D)}=20$ derniers $a_{46}^{(D)}$,..., $a_{65}^{(D)}$ sont affectés à une classe de protection $CL3^{(D)}$. Les classes $CL1^{(D)}$, $CL2^{(D)}$ et $CL3^{(D)}$ correspondent à des niveaux de protection décroissants.

Un module 14 opère une discrimination phonie/données et introduit un mot de redondance cyclique (CRC) à des fins de détection d'erreurs. Pour une trame de phonie issue du codeur 10, le module 14 définit des bits $a'_i$ ($-2 \leq i \leq 25$) par :

- $a'_0 = 0$ (bit de discrimination phonie/données) ;
- $a'_{i+1} = a_i^{(P)}$ pour $0 \leq i \leq 19$ (classe $CL1^{(P)}$) ;
- $a'_{21}$, $a'_{22}$ et $a'_{23}$ sont des bits de CRC tels que le polynôme $a'_0 Z^{23} + a'_1 Z^{22} + ... + a'_{22} Z + a'_{23}$ soit multiple de $1+Z+Z^3$ ;
- $a'_{-2} = a'_{-1} = a'_{24} = a'_{25} = 0$ pour l'initialisation du codage convolutionnel.

Pour une trame de données issue de la source 12, le module 14 définit des bits $a'_i$ ($-2 \leq i \leq 25$) et $a''_j$ ($-2 \leq j \leq 49$) par les étapes successives suivantes :

- $a'_0 = 1$ (bit de discrimination phonie/données) ;
- $a'_{i+1} = a_i^{(D)}$ pour $0 \leq i \leq 65$ ;
- $a'_{67}$,..., $a'_{71}$ sont des bits de CRC tels que le polynôme $a'_0 Z^{71} + a'_1 Z^{70} + ... + a'_{70} Z + a'_{71}$ soit multiple de $1+Z^2+Z^5$ ;
- $a''_j = a'_{j+24}$ pour $0 \leq j \leq 47$ (classes $CL2^{(D)}$ et $CL3^{(D)}$);
- $a'_{-2} = a'_{-1} = a'_{24} = a'_{25} = a''_{-2} = a''_{-1} = a''_{48} = a''_{49} = 0$ pour l'initialisation des codages convolutionnels.

Le module 14 est suivi par un module 16 qui effectue le codage à redondance, qui est un codage convolutionnel CC(2,1,3) dans l'exemple considéré. Le module 16 définit une trame T1' de $N=152$ bits $b_0$, $b_1$,..., $b_{151}$, les bits $b_0$ à $b_{51}$ étant donnés par :

- $b_{2i} = a'_i \oplus a'_{i-1} \oplus a'_{i-2}$ pour $0 \leq i \leq 25$ ;
- $b_{2i+1} = a'_i \oplus a'_{i-2}$ pour $0 \leq i \leq 25$,

les bits $b_{52}$ à $b_{151}$ pour une trame de phonie ($a'_0=0$) étant donnés par $b_n=a_{n-32}^{(P)}$ pour $52≤n≤151$ (pas de redondance pour les classes $CL2^{(P)}$ et $CL3^{(P)}$), et les bits $b_{52}$ à $b_{151}$ pour une trame de données ($a'_0=1$) étant obtenus par le même codage convolutionnel CC(2,1,3) :

- $b_{2j+52} = a''_j ⊕ a''_{j-1} ⊕ a''_{j-2}$ pour $0≤j≤49$ ;
- $b_{2j+53} = a''_j ⊕ a''_{j-2}$ pour $0≤j≤49$.

En sortie du module de codage convolutionnel 16, les bits $b_0$ à $b_{51}$ constituent le sous-ensemble redondant appelé E précédemment (L=52) et représentent les bits de la classe $CL1^{(P)}$ ou $CL1^{(D)}$ de la trame d'origine. Les bits b seront réordonnés avant le codage différentiel afin que les bits $b_{52}$ à $b_{103}$ dépendant des bits de la classe $CL2^{(P)}$ ou $CL2^{(D)}$ constituent le sous-ensemble appelé E' (L'=L=52). Les bits $b_{104}$ à $b_{151}$ constituent le sous-ensemble appelé E" (L"=48). Ces bits de E" dépendent des $M''^{(P)}=L''$ bits de la classe $CL3^{(P)}$ dans le cas des trames de phonie.

Le module 16 est suivi par un module 18 qui assure un entrelacement pour uniformiser les probabilités d'erreur dues au fading. Dans l'exemple considéré ici, l'entrelacement effectué par le module 18 assure en outre la distribution des bits permettant de maximiser le cardinal L' du sous-ensemble E'. L'entrelacement consiste à réaliser $b'_n=b_{tab\_entr(n)}$ pour $0≤n≤151$ où tab_entr(n) désigne la (n+1)-ième valeur d'une table d'entrelacement adaptée telle que par exemple :
tab_entr = [<u>55</u> **0** <u>56</u> **8** <u>64</u> **16** 112 <u>72</u> **24** 120 <u>80</u> **32** 128 <u>88</u> **40** 136 <u>96</u> **48** 144 <u>60</u> **4** 108 <u>68</u> **12** 116 <u>76</u> **20** 124 <u>84</u> **28** 132 <u>92</u> **36** 140 <u>100</u> **44** 148 <u>52</u> **2** 106 <u>58</u> **10** 114 <u>66</u> **18** 122 <u>74</u> **26** 130 <u>82</u> **34** 138 <u>90</u> **42** 146 <u>98</u> **50** 110 <u>62</u> **6** 118 <u>70</u> **14** 126 <u>78</u> **22** 134 <u>86</u> **30** 142 <u>94</u> **38** 150 <u>102</u> **46** 105 <u>54</u> **1** <u>57</u> 9 <u>65</u> **17** 113 <u>73</u> **25** 121 <u>81</u> **33** 129 <u>89</u> **41** 137 <u>97</u> **49** 145 <u>61</u> **5** 109 <u>69</u> **13** 117 <u>77</u> **21** 125 <u>85</u> **29** 133 <u>93</u> **37** 141 <u>101</u> **45** 149 <u>53</u> **3** 107 <u>59</u> **11** 115 <u>67</u> **19** 123 <u>75</u> **27** 131 <u>83</u> **35** 139 <u>91</u> **43** 147 <u>99</u> **51** 111 <u>63</u> **7** 119 <u>71</u> **15** 127 <u>79</u> **23** 135 <u>87</u> **31** **143** <u>95</u> **39** 151 <u>103</u> **47** 104]

Dans la table tab_entr ci-dessus, les chiffres gras indiquent les bits du sous-ensemble redondant E et les chiffres soulignés indiquent les bits du sous-ensemble E', les autres chiffres indiquant les bits du sous-ensemble E".

Un module 20 embrouille les bits $b'_n$ délivrés par le module d'entrelacement 18 et y ajoute les 8 bits de synchronisation. L'embrouillage utilise par exemple une séquence S(k) de période 127 définie par S(k)=0 pour $0≤k≤6$ et $S(k)=S(k-1) ⊕ S(k-7)$ pour $7≤k<127$. La trame embrouillée T2 est formée par le module 20 selon : $c_n = b'_n ⊕ S(emb+n)$ pour $0≤n≤151$, le paramètre d'embrouillage utilisé *emb* étant connu de l'émetteur et du récepteur. Les bits de synchronisation $c_{-8}, c_{-7},..., c_{-1}$ placés avant la trame T2 sont fixes, par exemple 01100010.

Le codage différentiel est effectué par un module 22. Les bits de synchronisation ne sont pas codés différentiellement : $d_i=c_i$ pour $-8≤i≤-1$. Le bit $d_{-1}=c_{-1}=0$ sert alors de bit d'initialisation pour le codage différentiel. L'expression du codage différentiel dans l'exemple considéré est $d_n= c_n ⊕ d_{f(n)}$ avec $f(n)=n-1-tab\_dif(n)$ où tab_dif est une table binaire construite pour obtenir la distribution souhaitée des bits des sous-ensembles E, E' et E" :
tab_dif=[000000010010010010010010010010010010010100100
100100100100100100100100000010010010010010010010100
100100100100100100100100100100100100100]

La séquence composée des 8 bits de synchronisation $d_{-8},...,d_{-1}$ et des N=152 bits de la trame T3 $d_0,...,d_{151}$ est adressée à un étage de modulation 24 qui produit le signal radio SE émis au moyen de l'antenne 26. La modulation utilisée est de type GMSK ("Gaussian Minimum Shift Keying") dans l'exemple considéré.

La figure 8 montre un dispositif récepteur associé au dispositif émetteur de la figure 7. Le signal radio $S_R$ reçu sur l'antenne 30 est d'abord démodulé par un étage 32. L'étage de démodulation 32 opère notamment la synchronisation des trames au moyen des 8 bits de synchronisation. L'étage de démodulation 32 produit les données de vraisemblance $r_{-8},...,r_{-1},r_0,r_1,...,r_{151}$ associées aux bits $d_{-8},...,d_{-1},d_0, d_1,..., d_{151}$.

Un module 34 effectue le décodage différentiel. Dans l'exemple considéré, il s'agit d'un décodage à décision dure : $ĉ_n=[1-sgn(r_n.r_{f(n)}]/2$ pour $0≤n≤151$, avec la fonction f précédemment définie. Les $ĉ_n$ ($0≤n≤151$) sont des premières estimations des bits $c_n$ de la trame T2. Le désembrouillage est effectué par un module 36 selon : $b̂'_n = ĉ_n ⊕ S(emb+n)$ pour $0≤n≤151$. Le désentrelacement est effectué par un module 38 selon $b̂_{tab\_entr(n)} = b̂'_n$ pour $0≤n≤151$.

Un décodeur correcteur d'erreurs 40 décode les L=52 estimations $b̂_0, b̂_1,..., b̂_{51}$ des bits $b_0, b_1,...,b_{51}$ relevant du sous-ensemble redondant E. Ce décodage est par exemple réalisé selon l'algorithme de Viterbi à décisions dures. On obtient ainsi des estimations $â'_i$ des bits $a'_i$ pour $0≤i≤23$.

Un module désigné par la référence 42 sur la figure 8 effectue ensuite la correction (éventuelle) des données de vraisemblance $r_n$. Le module 42 recode d'abord les bits $â'_0,...,â'_{23}$ selon le code convolutionnel CC(2,1,3) utilisé par le codeur 16 du dispositif émetteur, avec $â'_{-2}= â'_{-1}= â'_{24}=â'_{25}=0$ :

- $B̂_{2i} = â'_i ⊕ â'_{i-1} ⊕ â'_{i-2}$ pour $0≤i≤25$ ;
- $B̂_{2i+1} = â'_i ⊕ â'_{i-2}$ pour $0≤i≤25$.

Les bits $B̂_n$ ($0≤n≤51$) constituent les estimations corrigées des bits $b_n$ relevant du sous-ensemble redondant E. On note que les $B̂_n$ ($0≤n≤51$) pourraient également être produits directement par le treillis de Viterbi utilisé par le décodeur 40. Le module 42 détecte ensuite les bits du sous-ensemble redondant E dont les premières estimations sont erronées. Il s'agit des bits $c_{tab\_entr(n)}$ tels que $0 \leq n \leq 51$ et $\hat{b}_n \neq \hat{B}_n$. Pour chaque bit cm du sous-ensemble redondant E dont la première estimation a été détectée comme erronée, le module 42 inverse le signe de celle des deux données $r_m$, $r_{f(m)}$ qui a la plus petite valeur absolue. A partir des premières estimations $b_n$ fournies à l'entrée du décodeur 40 et des estimations corrigées correspondantes $B_n$, le module 42 peut ainsi exécuter les instructions suivantes :

```
Pour n = 0 à 51,
        Si  b̂ₙ ≠ B̂ₙ
                m = tab_entr(n)
                m'= m-1-tab_dif(m)
                Si |rₘ|>|rₘ'|
                        rₘ' = -rₘ'
                    Sinon
                        rₘ = -rₘ
                Fin Si
        Fin Si
Fin Pour
```

Si le décodeur convolutionnel fonctionnait sur la base de décisions douces, le module 42 utiliserait avantageusement les relations (5) et (6) précédemment évoquées pour modifier les valeurs absolues et, le cas échéant, les signes des données de vraisemblance $r_n$ associées aux bits du sous-ensemble redondant E. Ceci pourrait être effectué en exécutant les instructions suivantes (étant noté que $c'_{tab\_entr(n)} = B_n \oplus S(emb+tab\_entr(n))$):

```
Pour  n = 0 à 51,
        m = tab_entr(n)
        m'= m-1-tab_dif(m)
        s=1-2[B̂ₙ⊕S(emb+m)]
        rₘ= (rₘ+s.rₘ')/√2
        rₘ'=s.rₘ
Fin Pour
```

Si au moins une donnée de vraisemblance $r_n$ a été corrigée par le module 42, on procède de nouveau à un décodage différentiel ($c_n = [1 - sgn(r_n.r_{f(n)})]/2$ pour $0 \leq n \leq 151$), à un désembrouillage ($b'_n = c_n \oplus S(emb,n)$ pour $0 \leq n \leq 151$) et à un désentrelacement ($b_{tab\_entr(n)} = b'_n$ pour $0 \leq n \leq 151$) au moyen de modules respectifs 44, 46, 48 identiques aux modules 34, 36, 38 mais opérant sur les données $r_n$ corrigées.

La suite des opérations effectuées par le dispositif récepteur dépend de la nature de la trame considérée (phonie ou données). Un module 50 effectue cette discrimination sur la base du bit $â'_0$ fourni par le décodeur 40.

Dans le cas d'une trame de phonie ($â'_0 = 0$), un module 52 contrôle la validité des bits de CRC $â'_{21}$, $â'_{22}$ et $â'_{23}$ en vérifiant que le polynôme $â'_0 Z^{23} + ... + â'_{22} Z + â'_{23}$ est bien multiple de $1 + Z + Z^3$. En cas d'erreur, la trame est indiquée comme étant fausse au décodeur audio 54. Sinon, le décodeur audio 54 reçoit les $K^{(P)} = 120$ estimations $â_0, ..., â_{119}$ des bits d'information $a_0^{(P)}, ..., a_{119}(P)$ de la trame T1, données par :

$â_i = â'_{i+1}$ pour $0 \leq i \leq 19$ ; et

- $\hat{a}_i = \hat{b}_{i+32}$ pour $20 \leq i \leq 119$, les $\hat{b}_{i+32}$ étant ceux fournis par le module 38 ou, si au moins une donnée $r_n$ a été corrigée, par le module 48.

Dans le cas d'une trame de données ($\hat{a}'_0=1$), un décodage correcteur d'erreurs est appliqué aux bits $\hat{b}_{52},...,$ $b_{151}$ (fournis par le module 38 ou, si au moins une donnée $r_n$ a été corrigée, par le module 48) par un décodeur 56 fonctionnant également selon l'algorithme de Viterbi. On obtient ainsi des estimations $\hat{a}'_j$ des bits $a'_j$ pour $0 \leq j \leq 47$. Un module 58 contrôle la validité des bits de CRC $\hat{a}''_{43}, ...,\hat{a}''_{47}$ en vérifiant que le polynôme $\hat{a}'_0 Z^{71}+...+\hat{a}'_{23}Z^{48}+\hat{a}''_0{}^{47}+...$ $+\hat{a}''_{47}$ est bien multiple de $1+Z^2+Z^5$. En cas d'erreur, la trame est indiquée comme étant fausse au module 60 de traitement de données. Sinon, le module 60 de traitement de données reçoit les $K^{(D)}=66$ estimations $\hat{a}_0,...,\hat{a}_{65}$ des bits d'information $a_0{}^{(D)},...,a_{65}{}^{(D)}$ de la trame T1, données par :

- $\hat{a}_i = \hat{a}'_{i+1}$ pour $0 \leq i \leq 22$ ; et
- $\hat{a}_i = \hat{a}''_{i-23}$ pour $23 \leq i \leq 65$.

## Revendications

1. Procédé pour transmettre une première séquence (T1) de bits d'information, **caractérisé par** les étapes suivantes exécutées par un dispositif émetteur :

   - formation d'une seconde séquence de bits (T2) présentant de la redondance à partir de la première séquence, de façon que la seconde séquence inclue au moins un sous-ensemble redondant (E) constitué de L bits qui représentent M bits de la première séquence avec $0 \leq M \leq L$ ;
   - formation d'une troisième séquence de bits (T3) en appliquant à la seconde séquence un codage différentiel de la forme $d_n=c_n \oplus d_{f(n)}$, où $c_n$ et $d_n$ désignent respectivement les bits de rang n de la seconde et de la troisième séquence, f(n) désigne un entier au plus égal à n-1, et $\oplus$ désigne l'opération OU exclusif ; et
   - émission d'un signal représentant les bits de la troisième séquence (T3) dans un ordre déterminé,

   et par les étapes suivantes exécutées par un dispositif récepteur :

   - obtention de données de vraisemblance $r_n$ à partir du signal reçu du dispositif émetteur par l'intermédiaire d'un canal de transmission, le signe de chaque donnée de vraisemblance $r_n$ représentant une estimation, de fiabilité croissante avec la valeur absolue de $r_n$, de la valeur d'un bit respectif $d_n$ de la troisième séquence (T3) ;
   - calcul de premières estimations respectives ($c_n$) des bits du sous-ensemble redondant (E), chaque première estimation d'un bit $c_n$ du sous-ensemble redondant dépendant du signe de $r_n.r_{f(n)}$ ;
   - détection des bits du sous-ensemble redondant (E) ayant des premières estimations erronées en raison d'erreurs résultant du canal de transmission, en exploitant la redondance présente dans le sous-ensemble redondant ;
   - pour chaque bit $c_n$ du sous-ensemble redondant (E) dont la première estimation ($\hat{c}_n$) a été détectée comme erronée, modification du signe de celle des deux données de vraisemblance $r_n$ et $r_{f(n)}$ qui a la plus petite valeur absolue ;
   - obtention de secondes estimations respectives des bits de la seconde séquence, la seconde estimation d'un bit $c_n$ de la seconde séquence dépendant du signe de $r_n.r_{f(n)}$ ; et
   - obtention d'estimations des bits de la première séquence (T1) sur la base des secondes estimations des bits de la seconde séquence (T2).

2. Procédé selon la revendication 1, **caractérisé en ce que** le sous-ensemble redondant (E) se compose de L bits produits par un codage correcteur d'erreurs à partir de M bits de la première séquence (T1), avec $M \geq 1$.

3. Procédé selon la revendication 1, **caractérisé en ce que** le sous-ensemble redondant (E) se compose de L bits connus du dispositif récepteur.

4. Procédé selon l'une quelconque des revendications 1 à 3, **caractérisé en ce que** la structure de la seconde séquence (T2) et la fonction *f* sont choisies de façon à maximiser le nombre L', au plus égal à L, de bits $c_n$, de la seconde séquence n'appartenant pas au sous-ensemble redondant (E) tels qu'il y ait deux bits $c_{n1}$ et $c_{n2}$ du sous-ensemble redondant avec n'=f(n1) et f(n')=n2 ou f(n2).

5. Procédé selon l'une quelconque des revendications 1 à 4, **caractérisé en ce que** la seconde séquence (T2) inclut un nombre Q plus grand que 1 de sous-ensembles redondants $E_1$,..., $E_Q$, le sous-ensemble redondant $E_q$ étant constitué de $L_q$ bits qui représentent $M_q$ bits de la première séquence (T1) avec $0 \leq M_q < L_q$ pour $1 \leq q \leq Q$.

**6.** Procédé selon la revendication 5, **caractérisé en ce qu'**avant d'obtenir lesdites secondes estimations des bits de la seconde séquence (T2), le dispositif récepteur exécute la succession des étapes suivantes pour plusieurs des sous-ensembles redondants $E_q$ :

- calcul de premières estimations respectives ($\hat{c}_n$) des bits du sous-ensemble redondant $E_q$, chaque première estimation d'un bit $c_n$ du sous-ensemble $E_q$ dépendant du signe de $r_n.r_{f(n)}$ ;
- détection des bits du sous-ensemble redondant $E_q$ ayant des premières estimations erronées en raison d'erreurs résultant du canal de transmission, en exploitant la redondance présente dans le sous-ensemble $E_q$ ;
- pour chaque bit $c_n$ du sous-ensemble redondant $E_q$ dont la première estimation ($\hat{c}_n$) a été détectée comme erronée, modification du signe de celle des deux données de vraisemblance $r_n$ et $r_{f(n)}$ qui a la plus petite valeur absolue.

**7.** Procédé selon l'une quelconque des revendications 1 à 6, **caractérisé en ce que** après avoir calculé les premières estimations ($\hat{c}_n$) des bits du sous-ensemble redondant (E), le dispositif récepteur modifie, pour chaque bit $c_n$ du sous-ensemble redondant, les données de vraisemblance $r_n$ et $r_{f(n)}$ en fonction d'une estimation corrigée ($\hat{c}'_n$) du bit $c_n$ obtenue à partir des premières estimations en exploitant la redondance présente dans le sous-ensemble redondant (E), ladite modification affectant les valeurs absolues des données de vraisemblance $r_n$ et $r_{f(n)}$ et, lorsque l'estimation corrigée ($\hat{c}'_n$) du bit $c_n$ du sous-ensemble redondant (E) n'est pas en conformité avec ladite première estimation ($\hat{c}_n$) du bit $c_n$, le signe de celle des deux données de vraisemblance $r_n$ et $r_{f(n)}$ qui a la plus petite valeur absolue.

**8.** Procédé selon la revendication 7, **caractérisé en ce qu'**après modification des données de vraisemblance $r_n$ et $r_{f(n)}$ associées à un bit $c_n$ du sous-ensemble redondant (E), ces deux données de vraisemblance $r_n$ et $r_{f(n)}$ ont la même valeur absolue.

**9.** Procédé selon la revendication 8, **caractérisé en ce que** ladite modification des données de vraisemblance $r_n$ et $r_{f(n)}$ associées à un bit $c_n$ du sous-ensemble redondant (E) est de la forme :

$$r'_n = [r_n + r_{f(n)} \cdot (1 - 2\hat{c}'_n)]/\sqrt{2}$$

et

$$r'_{f(n)} = r'_n \cdot (1 - 2\hat{c}'_n)$$

où $r'_n$ et $r'_{f(n)}$ désignent les données de vraisemblance $r_n$ et $r_{f(n)}$ après modification et $\hat{c}'_n$ désigne l'estimation corrigée, telle que $c'_n = 0$ ou 1, du bit $c_n$ du sous-ensemble redondant.

**10.** Procédé de codage d'une première séquence (T1) de bits d'information, dans lequel on prévoit au moins une première classe de protection (CL1) pour M bits de la première séquence et une seconde classe de protection (CL2) pour M' bits de la première séquence, M et M' désignant deux entiers au moins égaux à 1, **caractérisé en ce que** :

- on forme une seconde séquence de bits (T2) présentant de la redondance à partir de la première séquence, de façon que la seconde séquence inclue au moins un premier sous-ensemble redondant (E) constitué de L bits qui représentent les M bits de la première classe de la première séquence avec M<L, et un second sous-ensemble (E') constitué de L' bits qui dépendent des M' bits de la seconde classe de la première séquence ;
- on forme une troisième séquence de bits (T3) en appliquant à la seconde séquence un codage différentiel de la forme $d_n = c_n \oplus d_{f(n)}$, où $c_n$ et $d_n$ désignent respectivement les bits de rang n de la seconde et de la troisième séquence, $f(n)$ désigne un entier au plus égal à n-1, et $\oplus$ désigne l'opération OU exclusif ; et
- on délivre un signal représentant les bits de la troisième séquence (T3) dans un ordre déterminé,

et **en ce que** la structure de la seconde séquence (T2) et la fonction $f$ sont choisies de façon que pour chaque bit $c_{n'}$ appartenant au second sous-ensemble (E') de la seconde séquence, il y ait au moins un bit $c_n$ appartenant

au premier sous-ensemble (E) de la seconde séquence tel que n'=f(n) ou f(n')=n ou f(n).

**11.** Procédé selon la revendication 10, **caractérisé en ce que** le nombre L' de bits du second sous-ensemble (E') de la seconde séquence (T2) est au plus égal au nombre L de bits du premier sous-ensemble (E) de la seconde séquence, et **en ce que** la structure de la seconde séquence (T2) et la fonction $f$ sont choisies de façon que pour chaque bit $c_{n'}$ appartenant au second sous-ensemble (E') de la seconde séquence, il y ait deux bits $c_{n1}$ et $c_{n2}$ appartenant au premier sous-ensemble (E) de la seconde séquence tels que n'=f(n1) et f(n')=n2 ou f(n2).

**12.** Procédé selon la revendication 11, **caractérisé en ce qu'**on prévoit une troisième classe de protection (CL3) pour M'' bits de la première séquence (T1), M'' désignant un entier au moins égal à 1, **en ce que** la seconde séquence inclut un troisième sous-ensemble (E'') constitué de L'' bits qui dépendent des M'' bits de la troisième classe de la première séquence, et **en ce que** la structure de la seconde séquence (T2) et la fonction $f$ sont choisies de façon que pour chaque bit $c_{n''}$ appartenant au troisième sous-ensemble (E'') de la seconde séquence, il y ait un seul bit $c_n$ appartenant au premier sous-ensemble (E) de la seconde séquence tel que n''=f(n) ou f(n'')=n ou f(n).

**13.** Procédé de correction d'une séquence de données de vraisemblance $r_n$ obtenues à partir d'un signal reçu d'un dispositif émetteur par l'intermédiaire d'un canal de transmission, le signe de chaque donnée de vraisemblance $r_n$ représentant une estimation, de fiabilité croissante avec la valeur absolue de $r_n$, de la valeur d'un bit respectif $d_n$ d'une séquence codée de bits (T3) résultant d'un codage différentiel d'une seconde séquence de bits (T2) par le dispositif émetteur, la seconde séquence de bits incluant au moins un sous-ensemble redondant (E) constitué de L bits qui représentent M bits d'information à communiquer avec $0 \leq M < L$, **caractérisé en ce que**, ledit codage différentiel étant de la forme $d_n = c_n \oplus d_{f(n)}$, $c_n$ et $d_n$ désignant respectivement les bits de rang n de la seconde séquence et de la séquence codée, $f(n)$ désignant un entier au plus égal à n-1, et $\oplus$ désignant l'opération OU exclusif, le procédé de correction comporte les étapes suivantes :

- calcul de premières estimations respectives ($\hat{c}_n$) des bits du sous-ensemble redondant (E), chaque première estimation d'un bit $c_n$ du sous-ensemble redondant dépendant du signe de $r_n \cdot r_{f(n)}$ ;
- détection des bits du sous-ensemble redondant (E) ayant des premières estimations erronées en raison d'erreurs résultant du canal de transmission, en exploitant la redondance présente dans le sous-ensemble redondant ; et
- pour chaque bit $c_n$ du sous-ensemble redondant (E) dont la première estimation ($\hat{c}_n$) a été détectée comme erronée, modification du signe de celle des deux données de vraisemblance $r_n$ et $r_{f(n)}$ qui a la plus petite valeur absolue.

**14.** Procédé selon la revendication 13, **caractérisé en ce qu'**après le calcul des premières estimations ($\hat{c}_n$) des bits du sous-ensemble redondant (E), on modifie, pour chaque bit $c_n$ du sous-ensemble redondant, les données de vraisemblance $r_n$ et $r_{f(n)}$ en fonction d'une estimation corrigée ($c'_n$) du bit $c_n$ obtenue à partir des premières estimations en exploitant la redondance présente dans le sous-ensemble redondant (E), ladite modification affectant les valeurs absolues des données de vraisemblance $r_n$ et $r_{f(n)}$ et, lorsque l'estimation corrigée ($c'_n$) du bit $c_n$ du sous-ensemble redondant (E) n'est pas en conformité avec ladite première estimation ($\hat{c}_n$) du bit $c_n$, le signe de celle des deux données de vraisemblance $r_n$ et $r_{f(n)}$ qui a la plus petite valeur absolue.

**15.** Procédé selon la revendication 14, **caractérisé en ce qu'**après modification des données de vraisemblance $r_n$ et $r_{f(n)}$ associées à un bit $c_n$ du sous-ensemble redondant (E), ces deux données de vraisemblance $r_n$ et $r_{f(n)}$ ont la même valeur absolue.

**16.** Procédé selon la revendication 15, **caractérisé en ce que** ladite modification des données de vraisemblance $r_n$ et $r_{f(n)}$ associées à un bit $c_n$ du sous-ensemble redondant (E) est de la forme :

$$r'_n = [r_n + r_{f(n)} \cdot (1 - 2\hat{c}'_n)] / \sqrt{2}$$

et

$$r'_{f(n)} = r'_n \cdot (1 - 2\hat{c}'_n)$$

où $r'_n$ et $r'_{f(n)}$ désignent les données de vraisemblance $r_n$ et $r_{f(n)}$ après modification et $\hat{c}'_n$ désigne l'estimation

corrigée, telle que $\hat{c}'_n=0$ ou 1, du bit $c_n$ du sous-ensemble redondant.

**Claims**

1. Process for transmitting a first sequence (T1) of information bits, **characterized by** the following steps executed by a sender device:

   - forming a second sequence of bits (T2) exhibiting redundancy based on the first sequence, in such a way that the second sequence includes at least one redundant subset (E) consisting of L bits which represent M bits of the first sequence with $0 \le M < L$;
   - forming a third sequence of bits (T3) by applying a differential coding of the form $d_n = c_n \oplus d_{f(n)}$ to the second sequence, where $c_n$ and $d_n$ denote the bits of rank n of the second and of the third sequence respectively, f (n) denotes an integer at most equal to n-1, and $\oplus$ denotes the exclusive OR operation; and
   - sending a signal representing the bits of the third sequence (T3) in a specified order,

   and by the following steps executed by a receiver device:

   - obtaining likelihood data $r_n$ based on the signal received from the sender device via a transmission channel, the sign of each likelihood data item $r_n$ representing an estimate, of reliability which increases with the absolute value of $r_n$, of the value of a respective bit $d_n$ of the third sequence (T3);
   - calculating respective first estimates $(\hat{c}_n)$ of the bits of the redundant subset (E), each first estimate of a bit $c_n$ of the redundant subset depending on the sign of $r_n \cdot r_{f(n)}$;
   - detecting the bits of the redundant subset (E) having erroneous first estimates due to errors resulting from the transmission channel, by exploiting the redundancy present in the redundant subset;
   - for each bit $c_n$ of the redundant subset (E) whose first estimate $(\hat{c}_n)$ has been detected as erroneous, modifying the sign of that of the two likelihood data items $r_n$ and $r_{f(n)}$ which has the smaller absolute value;
   - obtaining respective second estimates of the bits of the second sequence, the second estimate of a bit $c_n$ of the second sequence depending on the sign of $r_n \cdot r_{f(n)}$; and
   - obtaining estimates of the bits of the first sequence (T1) on the basis of the second estimates of the bits of the second sequence (T2).

2. Process according to Claim 1, **characterized in that** the redundant subset (E) is composed of L bits produced by an error-correcting coding based on M bits of the first sequence (T1), with $M \ge 1$.

3. Process according to Claim 1, **characterized in that** the redundant subset (E) is composed of L bits known to the receiver device.

4. Process according to any one of Claims 1 to 3, **characterized in that** the structure of the second sequence (T2) and the function f are chosen in such a way as to maximize the number L', at most equal to L, of bits $c_{n'}$ of the second sequence not belonging to the redundant subset (E) which are such that there are two bits $c_{n1}$ and $c_{n2}$ of the redundant subset with n'=f(n1) and f(n')=n2 or f(n2).

5. Process according to any one of Claims 1 to 4, **characterized in that** the second sequence (T2) includes a number Q larger than 1 of redundant subsets $E_1,...,E_Q$, the redundant subset $E_q$ consisting of $L_q$ bits which represent $M_q$ bits of the first sequence (T1) with $0 \le M_q < L_q$ for $1 \le q \le Q$.

6. Process according to Claim 5, **characterized in that** before obtaining said second estimates of the bits of the second sequence (T2), the receiver device executes the succession of the following steps for several of the redundant subsets $E_q$:

   - calculating respective first estimates $(\hat{c}_n)$ of the bits of the redundant subset $E_q$, each first estimate of a bit $c_n$ of the subset $E_q$ depending on the sign of $r_n \cdot r_{f(n)}$;
   - detecting the bits of the redundant subset $E_q$ having erroneous first estimates due to errors resulting from the transmission channel, by exploiting the redundancy present in the subset $E_q$;
   - for each bit $c_n$ of the redundant subset $E_q$ whose first estimate $(\hat{c}_n)$ has been detected as erroneous, modifying of the sign of that of the two likelihood data items $r_n$ and $r_{f(n)}$ which has the smaller absolute value.

7. Process according to any one of Claims 1 to 6, **characterized in that** after having calculated the first estimates ($\hat{c}_n$) of the bits of the redundant subset (E), the receiver device modifies, for each bit $c_n$ of the redundant subset, the likelihood data items $r_n$ and $r_{f(n)}$ as a function of a corrected estimate ($\hat{c}'_n$) of the bit $c_n$ obtained on the basis of the first estimates by exploiting the redundancy present in the redundant subset (E), said modification affecting the absolute values of the likelihood data items $r_n$ and $r_{f(n)}$ and, when the corrected estimate ($\hat{c}'_n$) of the bit $c_n$ of the redundant subset (E) is not in accord with said first estimate ($\hat{c}_n$) of the bit $c_n$, the sign of that of the two likelihood data items $r_n$ and $r_{f(n)}$ which has the smaller absolute value.

8. Process according to Claim 7, **characterized in that** after modification of the likelihood data items $r_n$ and $r_{f(n)}$ associated with a bit $c_n$ of the redundant subset (E), these two likelihood data items $r_n$ and $r_{f(n)}$ have the same absolute value.

9. Process according to Claim 8, **characterized in that** said modification of the likelihood data items $r_n$ and $r_{f(n)}$ associated with a bit $c_n$ of the redundant subset (E) is of the form:

$$r'_n = [r_n + r_{f(n)} \cdot (1-2\hat{c}'_n)]/\sqrt{2}$$

and
where $r'_n$ and $r'_{f(n)}$ denote the likelihood data items $r_n$ and $r_{f(n)}$ after modification and $\hat{c}'_n$ denotes the corrected estimate, which is such that $\hat{c}'_n = 0$ or $1$, of the bit $c_n$ of the redundant subset.

10. Process for coding a first sequence (T1) of information bits, in which there is provided at least a first protection class (CL1) for M bits of the first sequence and a second protection class (CL2) for M' bits of the first sequence, M and M' denoting two integers at least equal to 1, **characterized by** the steps of:

- forming a second sequence of bits (T2) exhibiting redundancy from the first sequence, in such a way that the second sequence includes at least a first redundant subset (E) consisting of L bits which represent the M bits of the first class of the first sequence with M<L, and a second subset (E') consisting of L' bits which depend on the M' bits of the second class of the first sequence;
- forming a third sequence of bits (T3) by applying a differential coding of the form $d_n = c_n \oplus d_{f(n)}$ to the second sequence, where $c_n$ and $d_n$ denote the bits of rank n of the second and of the third sequence respectively, f (n) denotes an integer at most equal to n-1, and $\oplus$ denotes the exclusive OR operation; and
- delivering a signal representing the bits of the third sequence (T3) in a specified order,

    and in that the structure of the second sequence (T2) and the function f are chosen such that for each bit $c_{n'}$ belonging to the second subset (E') of the second sequence, there is at least one bit $c_n$ belonging to the first subset (E) of the second sequence and such that n'=f(n) or f(n')=n or f(n).

11. Process according to Claim 10, **characterized in that** the number L' of bits of the second subset (E') of the second sequence (T2) is at most equal to the number L of bits of the first subset (E) of the second sequence, and **in that** the structure of the second sequence (T2) and the function f are chosen such that for each bit $c_{n'}$ belonging to the second subset (E') of the second sequence, there are two bits $c_{n1}$ and $c_{n2}$ belonging to the first subset (E) of the second sequence and such that n'=f(n1) and f(n')=n2 or f(n2).

12. Process according to Claim 11, **characterized in that** there is provided a third protection class (CL3) for M'' bits of the first sequence (T1), M'' denoting an integer at least equal to 1, **in that** the second sequence includes a third subset (E'') consisting of L'' bits which depend on the M'' bits of the third class of the first sequence, and **in that** the structure of the second sequence (T2) and the function f are chosen such that for each bit $c_{n''}$ belonging to the third subset (E'') of the second sequence, there is a single bit $c_n$ belonging to the first subset (E) of the second sequence and such that n''=f(n) or f(n'')=n or f(n).

13. Process for correcting a sequence of likelihood data $r_n$ obtained from a signal received from a sender device via a transmission channel, the sign of each likelihood data item $r_n$ representing an estimate, of reliability which increases with the absolute value of $r_n$, of the value of a respective bit $d_n$ of a coded sequence of bits (T3) resulting from a differential coding of a second sequence of bits (T2) by the sender device, the second sequence of bits including at least one redundant subset (E) consisting of L bits which represent M information bits to be communicated with $0 \leq M < L$, **characterized in that**, with said differential coding being of the form $d_n = c_n \oplus d_{f(n)}$, $c_n$ and $d_n$

denoting the bits of rank n of the second sequence and of the coded sequence respectively, f(n) denoting an integer at most equal to n-1, and $\oplus$ denoting the exclusive OR operation, the correction process includes the steps of:

- calculating respective first estimates $(\hat{c}_n)$ of the bits of the redundant subset (E), each first estimate of a bit $c_n$ of the redundant subset depending on the sign of $r_n.r_{f(n)}$;
- detecting the bits of the redundant subset (E) having erroneous first estimates due to errors resulting from the transmission channel, by exploiting the redundancy present in the redundant subset; and
- for each bit $c_n$ of the redundant subset (E) whose first estimate $(\hat{c}_n)$ has been detected as erroneous, modifying the sign of that of the two likelihood data items $r_n$ and $r_{f(n)}$ which has the smaller absolute value.

14. Process according to Claim 13, **characterized in that** after the calculation of the first estimates $(\hat{c}_n)$ of the bits of the redundant subset (E), the likelihood data items $r_n$ and $r_{f(n)}$ are modified, for each bit $c_n$ of the redundant subset, as a function of a corrected estimate $(c'_n)$ of the bit $c_n$ obtained on the basis of the first estimates by exploiting the redundancy present in the redundant subset (E), said modification affecting the absolute values of the likelihood data items $r_n$ and $r_{f(n)}$ and, when the corrected estimate $(c'_n)$ of the bit $c_n$ of the redundant subset (E) is not in accord with said first estimate $(\hat{c}_n)$ of the bit $c_n$, the sign of that of the two likelihood data items $r_n$ and $r_{f(n)}$ which has the smaller absolute value.

15. Process according to Claim 14, **characterized in that** after modification of the likelihood data items $r_n$ and $r_{f(n)}$ associated with a bit $c_n$ of the redundant subset (E), these two likelihood data items $r_n$ and $r_{f(n)}$ have the same absolute value.

16. Process according to Claim 15, **characterized in that** said modification of the likelihood data $r_n$ and $r_{f(n)}$ associated with a bit $c_n$ of the redundant subset (E) is of the form:

$$r'_n=[r_n+r_{f(n)} \cdot (1-2\hat{c}'_n)]/\sqrt{2}$$

and

$$r'_{f(n)} =r'_n \cdot (1-2\hat{c}'_n)$$

where $r'_n$ and $r'_{f(n)}$ denote the likelihood data items $r_n$ and $r_{f(n)}$ after modification and $\hat{c}'_n$ denotes the corrected estimate, which is such that $c'_n=0$ or 1, of the bit $c_n$ of the redundant subset.

**Patentansprüche**

1. Verfahren zum Übertragen einer ersten Sequenz (T1) von Informationsbits, **gekennzeichnet durch** die folgenden, von einer Sendevorrichtung auszuführenden Schritte:

- Bilden einer zweiten Bitsequenz (T2), welche eine Redundanz aufweist, ausgehend von der ersten Sequenz, so daß die zweite Sequenz mindestens eine Redundanzuntereinheit (E) beinhaltet, die aus L Bits besteht, welche für M Bits der ersten Sequenz stehen, wobei $0 \leq M < L$;
- Bilden einer dritten Bitsequenz (T3) unter Anwendung einer Differenzcodierung mit der Form $d_n = c_n \oplus d_{f(n)}$ auf die zweite Sequenz, wobei $c_n$ und $d_n$ die Bits mit dem Rang n der zweiten bzw. der dritten Sequenz bezeichnen, f(n) eine ganze Zahl bezeichnet, die höchstens gleich n-1 ist, und $\oplus$ die ausschließliche ODER-Operation bezeichnet; und
- Senden eines Signals, das die Bits der dritten Sequenz (T3) in einer vorgegebenen Reihenfolge darstellt,

sowie **durch** die folgenden, von einer Empfangsvorrichtung durchzuführenden Schritte:

- Erstellen von Wahrscheinlichkeitsdaten $r_n$ ausgehend von dem über einen Übertragungskanal von der Sendevorrichtung erhaltenen Signal, wobei das Vorzeichen eines jeden Wahrscheinlichkeitsdatums $r_n$ für eine Schätzung des Wertes eines jeweiligen Bit $d_n$ der dritten Sequenz (T3) steht, wobei die Zuverlässigkeit der Schätzung mit dem Absolutwert von $r_n$ zunimmt;
- Berechnen von jeweiligen ersten Schätzungen $(\hat{c}_n)$ der Bits der Redundanzuntereinheit (E), wobei jede erste

Schätzung eines Bit $c_n$ der Redundanzuntereinheit vom Vorzeichen von $r_n \cdot r_{f(n)}$ abhängt;

- Erfassen der Bits der Redundanzuntereinheit (E), die aufgrund von Fehlern infolge des Übertragungskanals erste fehlerhafte Schätzungen aufweisen, unter Nutzung der in der Redundanzuntereinheit vorhandenen Redundanz;
- Modifizieren des Vorzeichens desjenigen der beiden Wahrscheinlichkeitsdaten $r_n$ und $r_{f(n)}$ mit dem kleineren Absolutwert für jedes Bit $c_n$ der Redundanzuntereinheit (E), dessen erste Schätzung ($\hat{c}_n$) als fehlerhaft erfaßt wurde;
- Erstellen von jeweiligen zweiten Schätzungen der Bits der zweiten Sequenz, wobei die zweite Schätzung eines Bit $c_n$ der zweiten Sequenz vom Vorzeichen von $r_n \cdot r_{f(n)}$ abhängt; und
- Erstellen von Schätzungen der Bits der ersten Sequenz (T1) basierend auf den zweiten Schätzungen der Bits der zweiten Sequenz (T2).

2. Verfahren nach Anspruch 1, **dadurch gekennzeichnet, daß** sich die Redundanzuntereinheit (E) aus L Bits zusammensetzt, die durch eine Fehlerkorrektur-Codierung ausgehend von M Bits der ersten Sequenz (T1) erzeugt wurden, wobei $M \geq 1$.

3. Verfahren nach Anspruch 1, **dadurch gekennzeichnet, daß** sich die Redundanzuntereinheit (E) aus L der Empfangsvorrichtung bekannten Bits zusammensetzt.

4. Verfahren nach einem der Ansprüche 1 bis 3, **dadurch gekennzeichnet, daß** die Struktur der zweiten Sequenz (T2) und die Funktion $f$ so ausgewählt werden, daß die Anzahl L', die höchstens gleich L ist, von Bits $c_{n'}$ der zweiten Sequenz, die nicht der Redundanzuntereinheit (E) angehören, maximiert wird, so daß es zwei Bits $c_{n1}$ und $c_{n2}$ der Redundanzuntereinheit gibt, wobei n' = f(n1) und f(n') = n2 oder f(n2).

5. Verfahren nach einem der Ansprüche 1 bis 4, **dadurch gekennzeichnet, daß** die zweite Sequenz (T2) eine Anzahl Q von Redundanzuntereinheiten $E_1, ..., E_Q$ beinhaltet, die größer als 1 ist, wobei die Redundanzuntereinheit $E_q$ aus $L_q$ Bits besteht, die $M_q$ Bits der ersten Sequenz (T1) darstellen, wobei $0 \leq M_q < L_q$ für $1 \leq q \leq Q$.

6. Verfahren nach Anspruch 5, **dadurch gekennzeichnet, daß** die Empfangsvorrichtung vor dem Erstellen der zweiten Schätzungen der Bits der zweiten Sequenz (T2) die Abfolge der folgenden Schritte für mehrere der Redundanzuntereinheiten $E_q$ durchführt:

- Berechnen von jeweiligen ersten Schätzungen ($\hat{c}_n$) der Bits der Redundanzuntereinheit $E_q$, wobei jede erste Schätzung eines Bit $c_n$ der Untereinheit $E_q$ vom Vorzeichen von $r_n \cdot r_{f(n)}$ abhängt;
- Erfassen der Bits der Redundanzuntereinheit $E_q$, die aufgrund von Fehlern infolge des Übertragungskanals erste fehlerhafte Schätzungen aufweisen, unter Nutzung der in der Redundanzuntereinheit $E_q$ vorhandenen Redundanz;
- Modifizieren des Vorzeichens desjenigen der beiden Wahrscheinlichkeitsdaten $r_n$ und $r_{f(n)}$ mit dem kleineren Absolutwert für jedes Bit $c_n$ der Redundanzuntereinheit $E_q$, dessen erste Schätzung ($\hat{c}_n$) als fehlerhaft erfaßt wurde.

7. Verfahren nach einem der Ansprüche 1 bis 6, **dadurch gekennzeichnet, daß** die Empfangsvorrichtung nach dem Berechnen der ersten Schätzungen ($\hat{c}_n$) der Bits der Redundanzuntereinheit (E) für jedes Bit $c_n$ der Redundanzuntereinheit die Wahrscheinlichkeitsdaten $r_n$ und $r_{f(n)}$ in Abhängigkeit von einer korrigierten Schätzung ($\hat{c}'_n$) des Bit $c_n$ modifiziert, die ausgehend von den ersten Schätzungen unter Nutzung der in der Redundanzuntereinheit (E) vorhandenen Redundanz erhalten wurde, wobei sich die Modifikation auf die Absolutwerte der Wahrscheinlichkeitsdaten $r_n$ und $r_{f(n)}$ und, wenn die korrigierte Schätzung ($\hat{c}'_n$) des Bit $c_n$ der Redundanzuntereinheit (E) nicht mit der ersten Schätzung ($\hat{c}_n$) des Bit $c_n$ übereinstimmt, auf das Vorzeichen desjenigen der beiden Wahrscheinlichkeitsdaten $r_n$ und $r_{f(n)}$ mit dem kleineren Absolutwert auswirkt.

8. Verfahren nach Anspruch 7, **dadurch gekennzeichnet, daß** nach einer Modifikation der einem Bit $c_n$ der Redundanzuntereinheit (E) zugeordneten Wahrscheinlichkeitsdaten $r_n$ und $r_{f(n)}$ diese beiden Wahrscheinlichkeitsdaten $r_n$ und $r_{f(n)}$ den gleichen Absolutwert besitzen.

9. Verfahren nach Anspruch 8, **dadurch gekennzeichnet, daß** die Modifikation der einem Bit $c_n$ der Redundanzuntereinheit (E) zugeordneten Wahrscheinlichkeitsdaten $r_n$ und $r_{f(n)}$ die Form

$$r'_n = [r_n + r_{f(n)} \cdot (1 - 2\hat{c}'_n)] / \sqrt{2}$$

bzw.

$$r'_{f(n)} = r'_n \cdot (1 - 2\hat{c}'_n)$$

aufweist, wobei $r'_n$ und $r'_{f(n)}$ die Wahrscheinlichkeitsdaten $r_n$ und $r_{f(n)}$ nach Modifikation bezeichnen, und $\hat{c}'_n$ die korrigierte Schätzung, wie $c'_n = 0$ oder $1$, des Bit $c_n$ der Redundanzuntereinheit bezeichnet.

**10.** Verfahren zum Codieren einer ersten Sequenz (T1) von Informationsbits, bei dem mindestens eine erste Schutzklasse (CL1) für M Bits der ersten Sequenz und eine zweite Schutzklasse (CL2) für M' Bits der ersten Sequenz vorgesehen wird, wobei M und M' zwei ganze Zahlen bezeichnen, die mindestens gleich 1 sind, **dadurch gekennzeichnet, daß**:

- ausgehend von der ersten Sequenz eine zweite Bitsequenz (T2) gebildet wird, welche eine Redundanz aufweist, so daß die zweite Sequenz mindestens eine erste Redundanzuntereinheit (E) beinhaltet, die aus L Bits besteht, welche die M Bits der ersten Klasse der ersten Sequenz darstellen, wobei M < L, sowie eine zweite Untereinheit (E'), die aus L' Bits besteht, die von den M' Bits der zweiten Klasse der ersten Sequenz abhängen;
- eine dritte Bitsequenz (T3) gebildet wird durch Anwenden auf die zweite Sequenz einer Differenzcodierung mit der Form $d_n = c_n \oplus d_{f(n)}$, wobei $c_n$ und $d_n$ die Bits mit dem Rang n der zweiten bzw. der dritten Sequenz bezeichnen, f(n) eine ganze Zahl bezeichnet, die höchstens gleich n-1 ist, und $\oplus$ die ausschließliche ODER-Operation bezeichnet; und
- ein Signal geliefert wird, das die Bits der dritten Sequenz (T3) in einer vorgegebenen Reihenfolge darstellt,

sowie dadurch, daß die Struktur der zweiten Sequenz (T2) und die Funktion *f* so ausgewählt werden, daß es für jedes Bit $c_n$, das zur zweiten Untereinheit (E') der zweiten Sequenz gehört, mindestens ein Bit $c_n$ gibt, das zur ersten Untereinheit (E) der zweiten Sequenz gehört, wie n' = f(n) oder f(n') = n oder f(n).

**11.** Verfahren nach Anspruch 10, **dadurch gekennzeichnet, daß** die Anzahl L' von Bits der zweiten Untereinheit (E') der zweiten Sequenz (T2) höchstens gleich der Anzahl L von Bits der ersten Untereinheit (E) der zweiten Sequenz ist, und daß die Struktur der zweiten Sequenz (T2) und die Funktion *f* so ausgewählt werden, daß es für jedes Bit $c_n$, das zur zweiten Untereinheit (E') der zweiten Sequenz gehört, zwei Bits $c_{n1}$ und $c_{n2}$ gibt, die zur ersten Untereinheit (E) der zweiten Sequenz gehören, wie n' = f(n1) und f(n') = n2 oder f(n2).

**12.** Verfahren nach Anspruch 11, **dadurch gekennzeichnet, daß** eine dritte Schutzklasse (CL3) für M" Bits der ersten Sequenz (T1) vorgesehen wird, wobei M" eine ganze Zahl bezeichnet, die mindestens gleich 1 ist, dadurch, daß die zweite Sequenz eine dritte Untereinheit (E") beinhaltet, die aus L" Bits besteht, die von den M" Bits der dritten Klasse der ersten Sequenz abhängen, sowie dadurch, daß die Struktur der zweiten Sequenz (T2) und die Funktion *f* so ausgewählt werden, daß es für jedes Bit $c_n$, das zur dritten Untereinheit (E") der zweiten Sequenz gehört, ein einziges Bit $c_n$ gibt, das zur ersten Untereinheit (E) der zweiten Sequenz gehört, wie n" = f(n) oder f(n") = n oder oder f (n) .

**13.** Verfahren zum Korrigieren einer Sequenz von Wahrscheinlichkeitsdaten $r_n$, die ausgehend von einem von einer Empfangsvorrichtung über einen Übertragungskanal empfangenen Signal erhalten werden, wobei das Vorzeichen eines jeden Wahrscheinlichkeitsdatums $r_n$ eine Schätzung, deren Zuverlässigkeit mit dem Absolutwert von $r_n$ zunimmt, des Wertes eines jeweiligen Bit $d_n$ einer codierten Bitsequenz (T3) darstellt, die aus einer Differenzcodierung einer zweiten Bitsequenz (T2) durch die Sendevorrichtung resultiert, wobei die zweite Bitsequenz mindestens eine Redundanzuntereinheit (E) beinhaltet, die aus L Bits besteht, die M mitzuteilende Informationsbits darstellen, wobei $0 \le M < L$, **dadurch gekennzeichnet, daß** die Differenzcodierung die Form $d_n = c_n \oplus d_{f(n)}$ hat, wobei $c_n$ und $d_n$ die Bits mit dem Rang n der zweiten Sequenz bzw. der codierten Sequenz bezeichnen, f(n) eine ganze Zahl bezeichnet, die höchstens gleich n-1 ist, und $\oplus$ die ausschließliche ODER-Operation bezeichnet, und das Korrekturverfahren die folgenden Schritte aufweist:

- Berechnen von jeweiligen ersten Schätzungen ($\hat{c}_n$) der Bits der Redundanzuntereinheit (E), wobei jede erste Schätzung eines Bit $c_n$ der Redundanzuntereinheit vom Vorzeichen von $r_n \cdot r_{f(n)}$ abhängt;
- Erfassen der Bits der Redundanzuntereinheit (E), die aufgrund von Fehlern infolge des Übertragungskanals erste fehlerhafte Schätzungen aufweisen, unter Nutzung der in der Redundanzuntereinheit vorhandenen Redundanz; und

- Modifizieren des Vorzeichens desjenigen der beiden Wahrscheinlichkeitsdaten $r_n$ und $r_{f(n)}$ mit dem kleineren Absolutwert für jedes Bit $c_n$ der Redundanzuntereinheit (E), deren erste Schätzung ($\hat{c}_n$) als fehlerhaft erfaßt wurde.

14. Verfahren nach Anspruch 13, **dadurch gekennzeichnet, daß** nach der Berechnung der ersten Schätzungen ($\hat{c}_n$) der Bits der Redundanzuntereinheit (E) für jedes Bit $c_n$ der Redundanzuntereinheit die Wahrscheinlichkeitsdaten $r_n$ und $r_{f(n)}$ in Abhängigkeit von einer korrigierten Schätzung ($\hat{c}'_n$) modifiziert werden, die ausgehend von den ersten Schätzungen unter Nutzung der in der Redundanzuntereinheit (E) vorhandenen Redundanz erstellt wurde, wobei sich die Modifikation auf die Absolutwerte der Wahrscheinlichkeitsdaten $r_n$ und $r_{f(n)}$ und, wenn die korrigierte Schätzung ($\hat{c}'_n$) des Bit $c_n$ der Redundanzuntereinheit (E) nicht mit der ersten Schätzung ($\hat{c}_n$) des Bit $c_n$ übereinstimmt, auf das Vorzeichen desjenigen der beiden Wahrscheinlichkeitsdaten $r_n$ und $r_{f(n)}$ mit dem kleineren Absolutwert auswirkt.

15. Verfahren nach Anspruch 14, **dadurch gekennzeichnet, daß** nach dem Modifizieren der einem Bit $c_n$ der Redundanzuntereinheit (E) zugeordneten Wahrscheinlichkeitsdaten $r_n$ und $r_{f(n)}$ diese beiden Wahrscheinlichkeitsdaten $r_n$ und $r_{f(n)}$ den gleichen Absolutwert besitzen.

16. Verfahren nach Anspruch 15, **dadurch gekennzeichnet, daß** die Modifikation der einem Bit $c_n$ der Redundanzuntereinheit (E) zugeordneten Wahrscheinlichkeitsdaten $r_n$ und $r_{f(n)}$ die Form

$$r'_n = [r_n + r_{f(n)} \cdot (1 - 2\hat{c}'_n)] / \sqrt{2}$$

bzw.

$$r'_{f(n)} = r'_n \cdot (1 - 2\hat{c}'_n)$$

aufweist, wobei $r'_n$ und $r'_{f(n)}$ die Wahrscheinlichkeitsdaten $r_n$ und $r_{f(n)}$ nach Modifikation bezeichnen, und $\hat{c}'_n$ die korrigierte Schätzung, wie $c'_n = 0$ oder 1, der Redundanzuntereinheit bezeichnet.

# FIG.1.

# FIG.2.

# FIG.3.

FIG.4

FIG.5.

FIG.6.

SOURCE DONNÉES

CODEUR AUDIO

12

$a_k^{(D)}$

$a_k^{(P)}$

10

DISCRIMINATEUR ET CRC

14

$a_i', a_j''$

$a_i'$

CODAGE CONVOLUTIONNEL

16

$b_n$

ENTRELACEMENT

18

$b_n'$

20

EMBROUILLAGE / SYNCHRONISATION

$c_n$

CODAGE DIFFÉRENTIEL

22

$d_n$

MODULATION

24

26

$S_E$

# FIG.7.

FIG.8.

```
                    ⚡→Ⲯ—30
                         S_R
                              ┌─────────────────────┐
                              │    DÉMODULATION      │——32
                              └─────────────────────┘
                                        │ r_n
                              ┌─────────────────────┐
                              │ DÉCODAGE DIFFÉRENTIEL│——34
                              └─────────────────────┘
                                        │ ĉ_n
                              ┌─────────────────────┐
                              │   DÉSEMBROUILLAGE    │——36
                              └─────────────────────┘
                                        │ b̂'_n
                              ┌─────────────────────┐
                              │  DÉSENTRELACEMENT    │——38
                              └─────────────────────┘
                                        │ b̂_n
                              ┌─────────────────────┐
                              │   DÉCODAGE VITERBI   │——40
                              └─────────────────────┘
                                        │ â'_i                          42
              ┌──────────────────────────────────────────────────────┐
              │   CORRECTION DONNÉES  DE VRAISEMBLANCE                 │
              └──────────────────────────────────────────────────────┘
                     │ r_n
              ┌─────────────────────┐
              │ DÉCODAGE DIFFÉRENTIEL│——44
              └─────────────────────┘
                     │ ĉ_n
              ┌─────────────────────┐
              │   DÉSEMBROUILLAGE   │——46
              └─────────────────────┘
                     │ b̂'_n
              ┌─────────────────────┐        ┌─────────────────────┐
              │  DÉSENTRELACEMENT   │        │   DISCRIMINATION     │——50
              └─────────────────────┘        └─────────────────────┘
           48      │ b̂_n
                   ┌──────────────────────────┐
              56——│  DÉCODAGE VITERBI / E₂     │
                   └──────────────────────────┘
                          │ â"_j                              52
              ┌─────────────────────┐        ┌─────────────────────┐
          58——│  VÉRIFICATION CRC   │        │  VÉRIFICATION  CRC   │
              └─────────────────────┘        └─────────────────────┘
                     │ â_i                            │ â_i
              ┌─────────────────────┐        ┌─────────────────────┐
          60——│ TRAITEMENT DONNÉES  │        │   DÉCODEUR AUDIO     │
              └─────────────────────┘        └─────────────────────┘
                                                                    54
```

$$FIG.8.$$

Signals and blocks:

- 30 (antenne), $S_R$
- 32 DÉMODULATION, $r_n$
- 34 DÉCODAGE DIFFÉRENTIEL, $\hat{c}_n$
- 36 DÉSEMBROUILLAGE, $\hat{b}'_n$
- 38 DÉSENTRELACEMENT, $\hat{b}_n$
- 40 DÉCODAGE VITERBI, $\hat{a}'_i$
- 42 CORRECTION DONNÉES DE VRAISEMBLANCE, $r_n$
- 44 DÉCODAGE DIFFÉRENTIEL, $\hat{c}_n$
- 46 DÉSEMBROUILLAGE, $\hat{b}'_n$
- 48 DÉSENTRELACEMENT, $\hat{b}_n$
- 50 DISCRIMINATION
- 56 DÉCODAGE VITERBI / $E_2$, $\hat{a}''_j$
- 58 VÉRIFICATION CRC, $\hat{a}_i$
- 60 TRAITEMENT DONNÉES
- 52 VÉRIFICATION CRC, $\hat{a}_i$
- 54 DÉCODEUR AUDIO